# EUROPÄISCHE PATENTSCHRIFT

(11) **EP 3 370 489 B1**
(45) Veröffentlichungstag und Bekanntmachung des Hinweises auf die Patenterteilung: **26.05.2021**
(21) Anmeldenummer: 18000096.0
(22) Anmeldetag: 06.02.2018
(51) Int. Cl.: H05K 7/14

(54) **ELEKTRONIKMODUL FÜR EINEN ELEKTROMOTOR, INSBESONDERE EINES PUMPENAGGREGATS**
ELECTRONIC MODULE FOR AN ELECTRIC MOTOR, IN PARTICULAR A PUMP UNIT
MODULE ÉLECTRONIQUE POUR UN MOTEUR ÉLECTRIQUE, EN PARTICULIER D'UN GROUPE MOTOPOMPE

(30) Priorität: 02.03.2017 DE 102017001929
(43) Veröffentlichungstag der Anmeldung: 05.09.2018
(73) Patentinhaber: WILO SE, 44263 Dortmund (DE)
(72) Erfinder: Karns, Stephan, 59348 Lüdinghausen (DE); Schmelter, Tina, 58093 Hagen (DE); Rosenthal, Thomas, 44141 Dortmund (DE); Lapp-Emden, Christoph, 44263 Dortmund (DE)
(74) Vertreter: Cohausz Hannig Borkowski Wißgott

(56) Entgegenhaltungen:
- EP-A1- 2 779 371
- EP-A2- 3 092 712
- US-A1- 2006 044 762
- US-A1- 2015 077 955
- US-A1- 2016 381 822
- US-B2- 8 957 556

## Beschreibung

Die Erfindung betrifft allgemein ein Elektronikmodul für die Montage an einem Elektromotor, insbesondere eines Pumpenaggregats, wobei es vorzugsweise zur Montage an einer axialen Stirnseite des Elektromotors bestimmt ist. Im Besonderen betrifft die Erfindung ein Elektronikmodul mit einer Elektronik zur Steuerung und/ oder Regelung des Elektromotors, die in einem ein Unterteil und ein Oberteil umfassendes Gehäuse aufgenommen ist, in dem ein erster und ein zweiter Raumbereich vorhanden sind, welche durch eine Trennwand voneinander getrennt sind, wobei in dem ersten Raumbereich eine erste Leiterplatte mit leistungselektronischen Bauelementen einer Motorsteuereinheit zur Speisung des Elektromotors einliegt, die Betriebsspannungen einer ersten Spannungsebene trägt, und in dem zweiten Raumbereich eine zweite Leiterplatte mit systemelektronischen Bauelementen einer Systemsteuereinheit einliegt, die Betriebsspannungen einer zweiten, niedrigeren Spannungsebene trägt.

Elektronikmodule mit Steuerungs- und/ oder Regelungselektronik für Elektromotoren als Antriebe für Strömungsmaschinen wie Kreiselpumpen oder Lüfter sind allgemein bekannt, beispielsweise aus der deutschen Patentanmeldung DE10107248 A1, und haben in den vergangenen Jahren eine enorme Entwicklung vollzogen, bei der viele Steuerung- und Regelungs-, Überwachungs- und Diagnose-, Fernsteuerungs- sowie Anzeige- und Bedienfunktionen in die Elektronik integriert worden sind. Der damit verbundene Zuwachs elektronischer Bauelemente führte dabei zu einem Anwachsen der baulichen Größe des Gehäuses der Elektronikmodule. Dennoch werden stets kompakte Bauformen angestrebt, da die örtliche Einbaulage von Pumpenaggregaten mit Elektromotor und Elektronikmodul meist nur geringen Bauraum bietet. Gleichzeitig müssen aber auch elektrische und thermische Isolationen insbesondere die Wärmeabfuhr, die Betriebssicherheit und für eine vernünftige Marktresonanz auch ein ansprechendes Design im Blick der Konstrukteure gehalten werden.

Elektronikmodule der genannten Gattung sind beispielsweise auch aus den europäischen Patentanmeldungen EP 2607707 A1 und EP 2779371 A1 bekannt. Bei der EP 2607707 A1 ist vorgesehen, die Elektronik auf zwei Gehäuseteile aufzuteilen, von denen ein erstes Gehäuseteil, Axialgehäuse genannt, axial an eine Stirnseite des Elektromotors angesetzt ist, und das zweiten Gehäuseteil, Radialgehäuse genannt, radial an das Axialgehäuse angesetzt ist, so dass es seitlich am Elektromotor angeordnet ist. Das Radialgehäuse ist ein massives Druckgussteil aus einer Leichtmetalllegierung mit massiven Kühlrippen, die sich in Umfangsrichtung um das Motorgehäuse herum erstrecken. Das Radialgehäuse nimmt die Leistungsbauteile eines Drehzahlstellers auf, die ihre Abwärme an die Kühlrippen geben. Alle externen Leitungen, insbesondere auch die Versorgungsleitung werden durch entsprechende Öffnungen in das Axialgehäuse eingeführt und dort angeschlossen. Eine Aufteilung der Elektronik nach Spannungsebenen ist hier nicht erkennbar. Jedes Gehäuseteil ist mit einem eigenen Deckel verschlossen. Die Anzahl zusammenzufügender Bauteile und die verschiedenen Fügerichtungen führen hier zu einem vergleichsweise komplizierten Montageverfahren.

Die EP 2779371 A1 sieht die axiale Anordnung zweier Einzelgehäuse eines axial an einen Elektromotor angesetzten Elektronikmoduls vor, wobei in dem oberen Einzelgehäuse ein erster Elektronikaufnahmeraum und in dem unteren ein zweiter Elektronikaufnahmeraum vorhanden ist. Die Räume sind durch den einstückig mit den Seitenwänden ausgebildeten Boden des oberen Einzelgehäuses voneinander getrennt.

Die US 2015/0077955 A1 offenbart eine Motorelektronik aus mindestens zwei aufeinander montierten Gehäuseteilen, wobei sich in einem ersten Gehäuseteil ein Frequenzumrichter und in einem zweiten Gehäuseteil eine Steuerungselektronik befindet. Zwischen den Gehäuseteilen besteht eine elektrische Schnittstelle. Dies dient dazu, dieselbe Steuerungselektronik für Frequenzumrichter unterschiedlicher Leistungen verwenden zu können. Innerhalb der Steuerungselektronik ist eine Leiterplatte vorgesehen, deren Hochspannungsbauelemente in einem Raumbereich zusammengefasst sind, der vom übrigen Teil der Leiterplatte durch eine belüftete Trennwand getrennt ist.

Aufgabe der vorliegenden Erfindung ist es, ein alternatives kompaktes Elektronikmodul für einen Elektromotor bereitzustellen, das besonders einfach zu montieren ist, gleichzeitig eine besonders hohe Betriebssicherheit und Schutz vor elektrischen Schlägen bietet. Zusätzlich soll eine gute thermische Isolation empfindlicher elektronischer Bauteile gegeben sein.

Diese Aufgabe wird durch ein Elektronikmodul mit den Merkmalen des Anspruchs 1 gelöst. Vorteilhafte Weiterbildungen sind in den Unteransprüchen angegeben und werden nachfolgend erläutert.

Bei dem erfindungsgemäßen Elektronikmodul ist vorgesehen, dass die Trennwand ein separates Bauteil bildet, d.h. vom Ober- und Unterteil baulich unabhängig ist. Dies gewährt einen hohen Gestaltungsspielraum hinsichtlich der Form und Funktionsintegration und erleichtert die axiale Montage der Komponenten. Die Trennwand sorgt für eine elektrische und thermische Isolation zwischen den Leiterplatten. Der erste Raumbereich mitsamt der ersten Leiterplatte, die Trennwand und der zweite Raumbereich mitsamt der zweiten Leiterplatte sind axial übereinander angeordnet. Erste und zweite Leiterplatte liegen somit parallel zueinander und parallel zur Trennwand.

Während die untere bzw. erste Leiterplatte leistungselektronische Bauelemente der Motorsteuereinheit, beispielsweise eines Frequenzumrichters zur Drehzahlstellung des Elektromotors, trägt und im Betrieb für den Menschen schädliche Spannungen führt, beispielsweise eine Versorgungsspannung (220/230V, 50Hz oder 110V/60Hz), gegebenenfalls auch bis zu 400V am Zwischenkreis des Frequenzumrichters, liegen an der oberen, d.h. zweiten Leiterplatte, die systemelektronische Bauelemente der Systemsteuereinheit trägt, vorzugsweise nur Betriebsspannungen an, die niedriger sind als diejenigen der ersten Leiterplatte. Insbesondere handelt es sich dabei um für den Menschen unschädliche Niederspannungen oder Kleinspannungen wie beispielsweise SELV oder PELV. Die schädlichen Betriebsspannungen sind folglich abgeschirmt in dem Unterteil des Gehäuses angeordnet, d.h. nicht unmittelbar dem Installateur zugänglich, wodurch ein hohes Maß an Betriebssicherheit vorliegt.

Die Trennwand kann auf ihrer zum ersten Raumbereich gerichteten Unterseite metallisch beschichtet sein, um Störstrahlung der leitungselektronischen Bauelemente von den systemelektronischen Bauelementen abzuschirmen. Vorzugsweise ist diese Beschichtung geerdet, um durch die elektromagnetische Strahlung induzierte Spannungen abzuleiten.

Das Oberteil kann haubenartig geformt sein. In dem Oberteil kann ein axial über dem zweiten Raumbereich liegender, einen Anschlussraum bildender dritter Raumbereich ausgebildet und auf dem Oberteil eine den dritten Raumbereich abdeckende, abnehmbare Anzeige- und/ oder Bedieneinheit aufgesetzt sein. Somit sind sämtliche Komponenten des Elektronikmoduls in derselben Fügerichtung, nämlich axial montierbar (Bottom-Up), was die Herstellung des Elektronikmoduls 1 erheblich vereinfacht. Vorzugsweise verbleibt der übrige Teil des Oberteils frei von einer Abdeckung durch die Anzeige- und/ oder Bedieneinheit. Der dritte Raumbereich kann in Gestalt einer Vertiefung in der Stirnseite des Oberteils gebildet sein, wobei der Boden den Boden dieser Vertiefung bildet. Geeigneterweise kann sich die Vertiefung an den Seiten vom Boden stufenartig zur Stirnseite des Oberteils erheben, so dass eine umlaufende Stufe gebildet wird, auf der die Anzeige- und/ oder Bedieneinheit aufliegen kann. Die Anzeige- und/ oder Bedieneinheit kann dichtend mit dem Oberteil verbunden sein. Vorzugsweise kann dies dadurch erreicht sein, dass auf der zum Oberteil gerichteten Unterseite der Anzeige- und/ oder Bedieneinheit eine umlaufende Dichtung vorhanden, insbesondere angeformt oder angespritzt ist, mit welcher die Anzeige- und/ oder Bedieneinheit dichtend auf der Stufe in der Vertiefung des Oberteils aufliegt.

Vorzugsweise ragen in den Anschlussraum elektrische Anschlüsse, insbesondere Anschlussklemmen wie Schraub- oder Federklemmen der zweiten Leiterplatte durch einen Boden des Oberteils hinein, der die zweite Leiterplatte im Übrigen abdeckt, so dass die zweite Leiterplatte geschützt unter dem Boden liegt. Der Boden des Oberteils ist vorzugsweise einstückig mit den übrigen Wänden des Oberteils ausgebildet. Er dient ebenfalls der elektrischen und vor allem thermischen Isolation zwischen dem ersten und dem zweiten Raumbereich. Von besonderem Vorteil ist es, wenn die Anschlussklemmen farblich codiert sind, so dass eine Funktionszuordnung gegeben ist und die Gefahr einer Vertauschung der Anschlüsse vermieden wird.

Die Trennwand bildet zum Boden des Oberteils quasi einen Zwischenboden. Es ist dadurch gewährleistet, dass sämtliche stromführenden Bauteile und Leitungen der Elektronik für den Installateur unzugänglich sind. Um elektrische Leitungen an der Elektronik anzuschließen, muss sich der Installateur lediglich Zugang zu dem dritten Raumbereich durch Abnehmen der Anzeige- und/ oder Bedieneinheit verschaffen, wobei die elektronischen Bauelemente der Motorsteuereinheit und der Systemsteuereinheit hinter einer schützenden Wand, nämlich der Trennwand einerseits und dem Boden des Oberteils andererseits verborgen bleiben. Dies schützt zum einen die Elektronik beispielsweise vor mechanischer Beschädigung und vor dem Eindringen Kurzschluss verursachender Fremdkörper, zum anderen aber auch den Installateur vor der Berührung stromführender Bauteile, wobei hier die Gefahr eines elektrischen Schlages ohnehin bereits dadurch reduziert ist, dass die schädlichen Betriebsspannungen allesamt auf der im Unterteil vorhandenen Leiterplatte lokalisiert sind.

Allerdings sei angemerkt, dass auf der zweiten Leiterplatte auch zumindest ein potentialfreier Meldekontakt, beispielsweise für eine Sammelstörmeldung (SSM) oder eine Sammelbetriebsmeldung (SBM), vorhanden sein kann, an welchen bedarfsweise vom Installateur eine externe Schaltspannung zwischen 12V und 240V angelegt werden kann. Der Meldekontakt kann ein Öffner oder Schließer sein. Die Bereitstellung solcher Meldekontakte ist an sich bekannt und wird von Kundenseite häufig gewünscht. Bei den Meldekontakten kann es sich um Relaisausgänge handeln. Obgleich am Meldekontakt auch eine Schaltspannung über 24V anlegbar ist, wird dadurch das erfindungsgemäße Konzept der funktionalen Trennung der Spannungen und räumlichen Aufteilung auf verschiedene Spannungsebenen nicht durchbrochen, da werksseitig keine Beschaltung der Meldekontakte erfolgt, so dass die zweite Leiterplatte nach wie vor bei Auslieferung des Elektronikmoduls bzw. des Pumpenaggregats mit Elektromotor und Elektronikmodul zum Kunden nur Spannungen der zweiten Spannungsebene trägt, mithin also nur Kleinspannungen.

Soweit im Rahmen der vorliegenden Erfindung von einer Spannungsebene die Rede ist, ist damit keine einzelne, feste Spannung gemeint, sondern ein Spannungsbereich. Sinngemäß wird bei den üblicherweise in Motorelektroniken vorkommenden Spannungen erfindungsgemäß differenziert zwischen für den Menschen schädlichen und unschädlichen Spannungen, wobei die Ersteren der ersten Spannungsebene und die letzteren der zweiten Spannungsebene zugehörig sind.

Soweit im Rahmen der vorliegenden Erfindung von einem Oberteil und einem Unterteil sowie von einer Ober- und einer Unterseite etc. die Rede ist, so sind damit keine absoluten Richtungsangaben oder Ortsbezüge gemeint, weder bezogen auf die Gravitationskraft noch auf die räumliche Umgebung des Elektronikmoduls, in der die bestimmungsgemäße Montage zu erfolgen hat. Vielmehr ist mit den Präfixen "ober" und "unter" der relative Bezug der entsprechenden Teile zueinander sowie zum Elektromotor angesprochen. Es sei somit klargestellt, dass bei einer Montage des erfindungsgemäßen Elektronikmoduls an einer axialen Stirnseite des Elektromotors mit horizontaler Motorachse, das Unterteil ein "Hinterteil" und das Oberteil "Vorderteil" bezogen auf den Elektromotor und aus Sicht eines Bedieners, der vor der Anzeige und/ oder Bedieneinheit steht, bilden würde.

Zur Vereinfachung der Montage kann die zweite Leiterplatte mittels einer Rastverbindung/ Rückhalteelemente an der Trennwand gehalten, insbesondere eingeclipst sein bzw. werden. Hierdurch wird eine Vorfixierung der zweiten Leiterplatte erreicht. Dies erfolgt geeigneterweise an der zum Oberteil gerichteten Oberseite des Trennelements.

Vorzugsweise kann die Trennwand an ihrem Außenumfang einen zumindest teilweise umlaufenden, hochstehenden Rahmen aufweisen. Der Rahmen bewirkt eine Versteifung der Trennwand und verleiht ihr somit zusätzlich Stabilität. Vorzugsweise erstreckt sich der Rahmen rechtwinklig vom übrigen, parallel zur zweiten Leiterplatte liegenden Teil der Trennwand zum Oberteil hin.

Um zu verhindern, dass am Übergang zwischen Unter- und Oberteil Feuchtigkeit oder eine Flüssigkeit in den ersten Raumbereich eindringt, kann die Trennwand eine Dichtung zum Unterteil aufweisen. Geeigneterweise ist erfolgt die Abdichtung hier axial.

Zu diesem Zweck kann die Trennwand auf ihrer zum Unterteil gerichteten Unterseite randseitig eine umlaufende Dichtung aufweisen, die in dichtender Anlage zum Unterteil steht, insbesondere auf der Oberseite einer Umfangskante des Unterteils aufliegt. Um die Dichtung lagesicher auszubilden, kann sie direkt an der Trennwand angeformt oder angespritzt sein. Sie bildet somit kein separat zu montierendes Bauteil. Die Dichtung kann die Umfangskante auch formschlüssig innen und/ oder außen übergreifen, so dass ein guter Sitz und hohe Dichtwirkung erreicht wird.

Gemäß einer vorteilhaften Weiterbildung kann die Trennwand eine Dichtung zum Oberteil aufweisen. Geeigneterweise ist erfolgt die Abdichtung hier radial. Zu diesem Zweck kann die Trennwand außenseitig am Rahmen eine umlaufende Dichtlippe aufweisen, die in dichtender Anlage zum Oberteil, insbesondere zur Innenseite der Seitenwände des Oberteils steht, so dass am Übergang zwischen Unter- und Oberteil keine Feuchtigkeit bzw. keine Flüssigkeit in den zweiten Raumbereich eindringen kann. Um die Dichtlippe lagesicher auszubilden, kann sie direkt an der Trennwand angeformt oder angespritzt sein. Sie bildet somit kein separat zu montierendes Bauteil.

Gemäß einer vorteilhaften Weiterbildung können die Dichtung zum Unterteil und die Dichtung, insbesondere die Dichtlippe zum Oberteil in einander übergehen. Der Übergang kann gemäß einer Variante nur punktuell sein. Dies hat im Falle des Anspritzens der Dichtung den Vorteil, dass weniger Angüsse benötigt werden, durch die die elastische Formmasse in die die Dichtungen formende Kavität eingebracht wird. Gemäß einer anderen Variante können die beiden Dichtungen derart in einander übergehen, dass sie eine einzige Formdichtung bilden, die dann eine erste Dichtfläche zum Unterteil und eine zweite Dichtfläche insbesondere mit Dichtlippe zum Oberteil aufweist. Auch hierdurch kann die Anzahl der Angüsse zur Ausbildung der Formdichtung reduziert werden. Die Dichtlippe kann sich, im Querschnitt betrachtet, schräg vom Rahmen zum Unterteil erstrecken, wodurch eine hohe Dichtwirkung erreicht wird.

Um die Trennwand zu versteifen können ober- und/ oder unterseitig sich lateral erstreckende Verstärkungsstrukturen in Gestalt rippenartiger Vorsprünge vorhanden sein. Diese können vorzugsweise in wabenförmiger Geometrie ausgeführt sein, wodurch zudem die Entstehung und Ausbreitung mechanischer Schwingungen gedämpft wird.

Von besonderem Vorteil ist es, wenn die Trennwand in ihrem mittleren/ einem zentralen Bereich eine sich zur zweiten Leiterplatte erhebende Stützrippe zum Abstützen der zweiten Leiterplatte aufweist. Somit wird verhindert, dass sich die zweite Leiterplatte bei einer Druckkraft nicht durchbiegt. Sinnvollerweise erstreckt sich die Stützrippe unterhalb entlang der in den dritten Raumbereich ragenden elektrischen Kontakte bzw. Anschlussklemmen, da hier in der Regel beim Anschließen einer Leitung eine Druckkraft auf die Anschlussklemmen ausgeübt wird.

Das erfindungsgemäße Elektronikmodul kann eine von außen zugängliche elektrisch-mechanische Schnittstelle aufweisen, die sich rückseitig in den ersten Raumbereich hineinerstreckt und elektrisch mit der ersten Leiterplatte verbunden, mithin also der ersten Spannungsebene zugeordnet ist. An die Schnittstelle kann eine Versorgungsleitung respektive ein Netzstecker zur Versorgung des Elektronikmoduls mit einer Versorgungsspannung (z.B. 110V, 230V, 400V) angeschlossen werden. Die Schnittstelle ist somit vom zweiten und vor allem vom dritten Raumbereich räumlich getrennt, und somit bei der Herstellung elektrischer Verbindungen an den elektrischen Anschlüssen im dritten Raumbereich auch nicht zugänglich, wodurch ebenfalls ein Schutz vor gefährlicher elektrischer Spannung gegeben ist. Die Schnittstelle kann in Gestalt eines Steck- oder Buchsenkontaktes ausgeführt sein, in den ein korrespondierender Buchsen- oder Steckkontakt am Ende der Versorgungsleitung, idealerweise also der Netzstecker ansteckbar ist.

Gemäß einer vorteilhaften Ausführungsvariante kann die Schnittstelle in einem von der ersten und zweiten Leiterplatte räumlich getrennten Trägerelement angeordnet sein. Dies vereinfacht die Montage, da die erste Leiterplatte durch rein axiales Fügen in das Unterteil eingesetzt werden kann.

Um auch das Trägerelement axial zu fügen, kann in einer Seitenwand des Unterteils eine zum Oberteil hin offene Seitenöffnung vorhanden sein, in die das Trägerelement einsetzbar ist und durch die die Schnittstelle von außen zugänglich ist. In seiner montierten Lage liegt das Trägerelement geeigneterweise rechtwinklig zur ersten Leiterplatte, insbesondere auch zur zweiten Leiterplatte.

Vorzugsweise sind das Trägerelement und die Seitenöffnung in ihrer Form und Größe derart korrespondierend ausgestaltet, dass das Trägerelement randseitig formschlüssig an der Seitenwand, insbesondere dichtend, in oder an der Seitenöffnung an- oder einliegt.

Idealerweise ist räumlich neben, vorzugsweise oberhalb der Schnittstelle zumindest eine zweite elektrisch-mechanische Schnittstelle auf dem Trägerelement vorhanden. Die erste und zweite Schnittstelle sind somit über das gemeinsame Trägerelement mechanisch miteinander verbunden. Die zweite Schnittstelle kann beispielsweise dem datentechnischen Anschluss eines zweiten Elektronikmoduls eines weiteren, eine Strömungsmaschine antreibenden Elektromotors dienen, so dass beispielsweise eine Doppelpumpenanordnung geschaffen werden kann. Alternativ kann an die zweite Schnittstelle oder an eine weitere zweite Schnittstelle ein externes Gerät, beispielsweise ein Router eines Netzwerks, ein externer Sensor, ein Aktor, ein Datensammler, ein Computer oder ein anderes tragbares Auslese- und/ oder Bediengerät angeschlossen werden, um Daten von und/ oder zu dem Elektronikmodul zu übertragen. Diese Aufzählung ist nicht abschließend. Insbesondere ist aber erkennbar, dass die zweite Schnittstelle oder weitere Schnittstelle bestimmungsgemäß Daten und/ oder Informationen uni- oder bidirektional kabelgebunden überträgt, mithin also eine Datenschnittstelle bildet. Entsprechend kann hier ein Datenstecker angeschlossen werden. Dies schließt jedoch nicht aus, dass über die zweite oder weitere Schnittstelle auch eine Spannungsversorgung des angeschlossenen Geräts erfolgt. Dies ist ebenfalls möglich.

Die zweite oder weitere Schnittstelle ist/ sind der zweiten Spannungsebene zugeordnet und elektrisch mit der zweiten Leiterplatte verbunden. Um eine leichte und schnelle Anschließbarkeit zu gewährleisten, können die weitere oder weiteren Schnittstellen ebenfalls in Gestalt eines Steck- oder Buchsenkontaktes ausgeführt sein, in den ein korrespondierender Buchsen- oder Steckkontakt am Ende einer Datenleitung, insbesondere ein Datenstecker einsteckbar ist.

Das Trägerelement bildet mitsamt der ersten und der zumindest einen zweiten Schnittstelle eine Einheit, mithin eine Schnittstelleneinheit. Gemäß einer vorteilhaften Weiterbildung weist das Elektronikmodul somit eine von der ersten und zweiten Leiterplatte räumlich getrennte Schnittstelleneinheit mit wenigstens zwei nebeneinander liegenden elektrischen Schnittstellen, insbesondere Steck- oder Buchsenkontakten auf, die miteinander über ein gemeinsames Trägerelement verbunden sind, wobei eine erste der Schnittstellen der ersten Spannungsebene zum Anschließen eines Netzsteckers und zumindest eine zweite der Schnittstellen mit der zweiten Spannungsebene zum Anschließen eines Datensteckers zugeordnet ist. Eine Verbindung der ersten und zweiten Leiterplatte miteinander erfolgt über die Schnittstelleneinheit nicht.

Die Zuordnung der ersten Schnittstelle zur ersten Spannungsebene kann derart erfolgen, dass die Schnittstelleneinheit bzw. das Trägerelement auf Steckkontakte der ersten Leiterplatte gesteckt ist, die in einen im Trägerelement ausgebildeten Aufnahmeraum für den Netzstecker hineinragen und von diesem direkt kontaktierbar sind. Somit stellt die Schnittstelleneinheit den elektrischen Teil der ersten Schnittstelle erst nach ihrer Montage bereit. Der mechanische Teil der ersten Schnittstelle in Gestalt des Aufnahmeraums und gegebenenfalls einer Geometrie für eine sichere und lösbare Verbindung ist dagegen im Trägerelement ausgebildet.

Die Steckkontakte sind geeigneterweise randseitig auf der ersten Leiterplatte angeordnet und ragen durch Öffnungen im Trägerelement in den Aufnahmeraum hinein, wo sie direkt von dem Netzstecker kontaktierbar sind. Bei den Steckkontakten kann es sich beispielsweise um Flachkontakte, insbesondere Messerkontakte handeln, die eine große Kontaktfläche zur Leistungsübertragung bereitstellen. Durch ein axiales bauliches Zusammenfügen der Schnittstelleneinheit und des Unterteils kann somit gleichzeitig direkt die elektrische Verbindung zwischen der ersten Schnittstelle und der ersten Leiterplatte hergestellt werden.

Alternativ kann die elektrische Verbindung zwischen der ersten Schnittstelle und der ersten Leiterplatte nicht direkt, sondern über ein oder mehrere Kabel erfolgen. So können die Enden des Kabels oder der Kabel entweder direkt mit der ersten Leiterplatte bzw. elektrischen Kontakten der ersten Schnittstelle im Trägerelement verlötet oder mit Steckkontakten versehen sein, die in entsprechende Gegensteckkontakte an der ersten Leiterplatte bzw. am Trägerelement einzustecken bzw. eingesteckt sind. Ferner kann auch ein Kabelende gelötet und das andere mittels Steckkontakten gesteckt sein. Die Gegensteckkontakte müssen dabei nicht unbedingt randseitig auf der ersten Leiterplatte vorhanden sein, so dass durch eine Kabelverbindung eine höhere Flexibilität bei der Platzierung der Kontakte auf der ersten Leiterplatte gegeben ist.

Auch die elektrische Verbindung der der zweiten Spannungsebene zugeordneten zweiten und/ oder weiteren Schnittstelle mit der zweiten Leiterplatte kann über einzelne oder ein gemeinsames Kabel, beispielsweise ein oder zwei Flachbandkabel erfolgen.

Um die elektrische Verbindung von der Schnittstelleneinheit zur zweiten Leiterplatte zu ermöglichen, kann in der Trennwand eine Ausnehmung vorhanden sein, durch die das oder die Kabel zur zweiten Leiterplatte hindurchgeführt ist bzw. sind. In dieser Ausführungsvariante sind somit die Steckkontakte auf der zweiten Leiterplatte durch die Ausnehmung zugänglich.

Bei den Steckkontakten auf der zweiten Leiterplatte kann es sich beispielsweise um Kontaktstifte, insbesondere Stift- oder Steckerleisten, vorzugsweise als SMD (Surface Mounted Device) handeln. Von besonderem Vorteil ist es jedoch, wenn die Steckkontakte als Oberflächenkontakte auf der zweiten Leiterplatte ausgebildet sind und gemeinsam einen Anschlussbereich für einen Platinenrandstecker bilden. Somit werden keine aufgelöteten Bauteile auf der zweiten Leiterplatte benötigt, um diese zu kontaktieren. Idealerweise kann sich die zweite Leiterplatte mit ihrem Anschlussbereich über die Ausnehmung hinweg erstrecken, so dass ein Flachbandkabel vom Platinenrandstecker, der den Anschlussbereich kontaktiert rechtwinklig weg- und durch die Ausnehmung zur Schnittstelleneinheit hingeführt werden kann.

Auf seiner zum ersten Raumbereich gerichteten Rückseite kann das Trägerelement ebenfalls Steckkontakte aufweisen, die mit den elektrischen Kontakten der zweiten oder weiteren Schnittstelle auf der Vorderseite des Trägerelements verbunden sind. Idealerweise können auch diese Steckkontakte als Oberflächenkontakte auf einer Leiterplatte gebildet sein, die sich durch das Trägerelement von der Vorderseite zur Rückseite hindurch erstreckt. Somit kann die Kontaktierung der zweiten oder weiteren Schnittstelle rückseitig des Trägerelements ebenfalls durch einen Platinenrandstecker erfolgen.

Die Schnittstelleneinheit kann somit aus dem Trägerelement und einer Leiterplatte bestehen, die die elektrischen Kontakte der zumindest einen zweiten Schnittstelle bereitstellt. Außer Leiterbahnen und Kontakten am Ende der Leiterbahnen weist die Leiterplatte vorzugsweise nicht auf, insbesondere keine elektrischen oder elektronischen Bauteile.

Das Trägerelement kann geeigneterweise ein Formteil aus Kunststoff sein. Vorzugsweise erstreckt sich die Leiterplatte in die zweite und die weitere Schnittstelle hinein, so dass nur diese einzige Leiterplatte benötigt wird. Dabei kann die Leiterplatte Y-förmig ausgebildet sein, so dass sie auf der Rückseite einen gemeinsamen Anschlussbereich für die zweite und weitere Schnittstelle bereitstellt, so dass beide Schnittstellen mit einem einzigen Platinenrandstecker zur zweiten Leiterplatte verbunden werden können. Somit verringert sich der Aufwand bei der Herstellung der elektrischen Verbindung zwischen Schnittstelleneinheit und zweiter Leiterplatte.

Die Anzeige- und/ oder Bedieneinheit umfasst vorzugsweise ein Elektronikmodul und eine dieses abdeckende Blende. Die Blende ist einerseits ein Designelement, das dem Elektronikmodul sowohl farblich als auch hinsichtlich seiner Form ein charakteristisches Aussehen verleiht und zudem eine hohe Flexibilität in der Form- und Farbgestaltung ermöglicht. Zudem dient es der mechanischen Befestigung des Elektronikmoduls, welches unterseitig an der Blende gehalten, insbesondere über wenigstens eine Rastverbindung gehalten sein kann, wobei die Blende wiederum an dem Oberteil lösbar befestigt, insbesondere schraubbefestigt sein kann. Um hier die Montage zu vereinfachen, kann diese lagesichere Befestigung am Unterteil nur an einer Seite der Anzeige- und/ oder Bedieneinheit erfolgen, wobei an der gegenüberliegenden Seite wenigstens ein Vorsprung vorhanden sein kann, der in eine korrespondierende Vertiefung am Oberteil lose eingreift. Die Montage des Oberteils kann derart erfolgen, dass die Anzeige- und/ oder Bedieneinheit in einem Winkel auf das Oberteil gesetzt wird, so dass der oder die Vorsprünge in die korrespondierende Vertiefung oder korrespondierenden Vertiefungen zum Einliegen gelangt/ gelangen, woraufhin dann die Anzeige- und/ oder Bedieneinheit zum Oberteil hin geschwenkt wird, wobei die Schwenkachse durch den Vorsprung/ die Vorsprünge verläuft, und an dem dem Vorsprung oder den Vorsprüngen gegenüberliegenden Ende mit dem Oberteil mittels Schrauben fixiert wird. Der Verschraubungsaufwand wird somit auf ein Minimum reduziert.

Die Anzeige- und/ oder Bedieneinheit deckt das Oberteil sinnvollerweise nicht vollflächig ab, sondern nur den nach oben offenen dritten Raumbereich, der wie eine wannenförmige Vertiefung in der axialen Stirnseite des Oberteils gestaltet sein kann, so dass der diese Vertiefung umgebende Bereich der Stirnseite des Oberteils eine Außenfläche des Elektronikmoduls ist. Die Anzeige- und/ oder Bedieneinheit bildet somit keinen Deckel des gesamten Elektronikmoduls und ist auch nicht in einen solchen Deckel integriert. Sie bildet vielmehr ein separates Modul, dessen laterale Abmessungen kleiner sind als die des Oberteils und das lediglich eine Abdeckung für einen Teil des Oberteils darstellt.

Von besonderem Vorteil ist es, wenn die Anzeige- und/ oder Bedieneinheit im Betrieb des Elektromotors unter Fortführung des Betriebs abnehmbar ist. Somit muss der Elektromotor respektive das Pumpenaggregat nicht außer Betrieb gesetzt werden, um die Anzeige- und/ oder Bedieneinheit zu wechseln.

Geeigneterweise ist das Oberteil aus Kunststoff spritzgegossen, insbesondere aus einem thermisch und elektrisch isolierenden Kunststoff. Das Unterteil ist vorzugsweise im Druckguss aus Metall, insbesondere einem Leichtmetall wie Aluminium oder einer Leichtmetalllegierung hergestellt, so dass es Wärme gut aufnehmen, leiten und abgeben kann.

Gemäß einer bevorzugen Weiterbildung kann die Trennwand mehrere hohlzylindrische Kabelführungen aufweisen, die mit Öffnungen im Oberteil fluchten. Ein durch die Öffnungen in den dritten Raumbereich hinein geführtes Kabel ist somit auch durch die Kabelführungen hindurchgesteckt. Die Kabelführungen bieten die Möglichkeit, einen Einführstutzen für das Kabel stabil zu befestigen, so dass auf eine Befestigung am Oberteil verzichtet werden kann. Idealerweise kann für die Befestigung eines solchen Einführstutzens in den Kabelführungen ein Innengewinde vorhanden sein, um einen entsprechenden Teil des Einführstutzens aufzunehmen, der mit einem korrespondierenden Außengewinde versehen ist. Der Einführstutzen entspricht in diesem Fall einer Kabelverschraubung, beispielsweise einer PG-Verschraubung.

Vorzugsweise ist das erfindungsgemäße Elektronikmodul Teil des Kreiselpumpenaggregats.

Weitere Vorteil und Merkmale der Erfindung werden nachfolgend anhand eines Ausführungsbeispiels und der beigefügten Figuren näher erläutert. Dabei zeigen:
- Fig. 1:: Ein Strukturbild der elektrischen Funktionsblöcke eines erfindungsgemäßen Elektronikmoduls
- Fig. 2:: eine Explosionsdarstellung eines Ausführungsbeispiels eines erfindungsgemäßen Elektronikmoduls
- Fig. 3:: ein vergrößerter Ausschnitt aus Fig. 2, der die Schnittstelleneinheit und deren Kontaktierung an der ersten Leiterplatte zeigt
- Fig. 4:: ein vergrößerter Ausschnitt aus Fig. 1, der die Trennwand zeigt
- Fig. 5:: ein vergrößerter Ausschnitt aus Fig. 1, der das Elektronikmodul der Anzeige- und/ oder Bedieneinheit zeigt

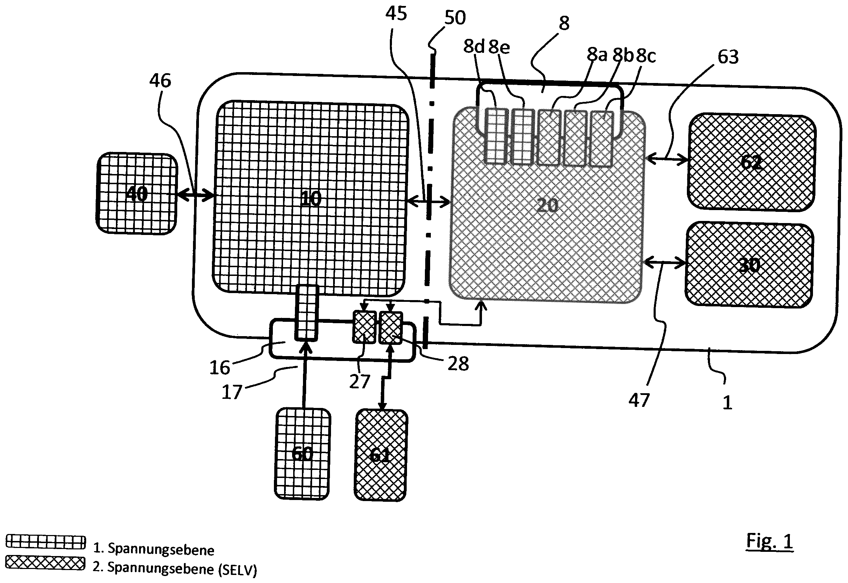

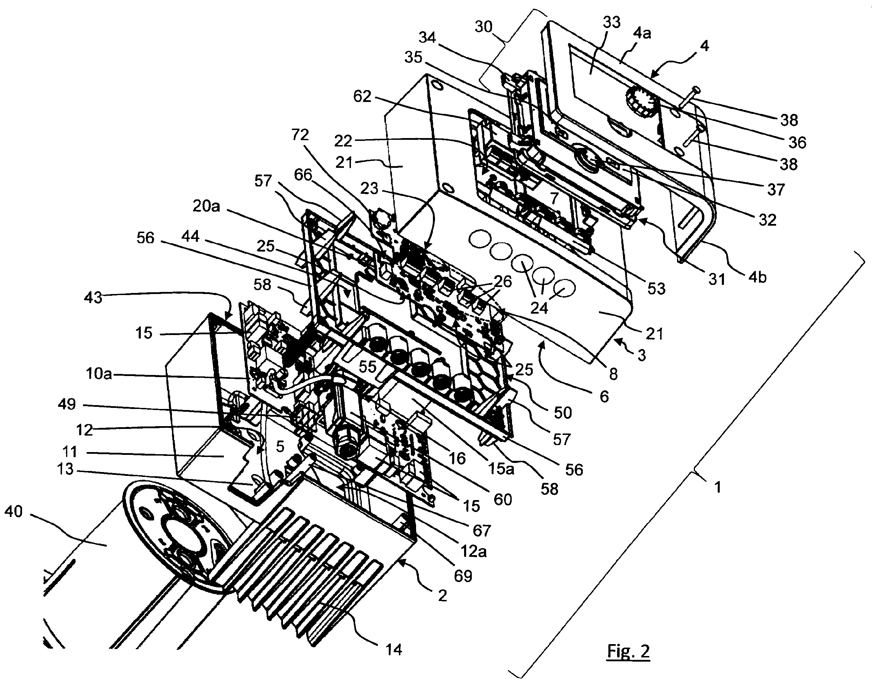

Fig. 1 zeigt eine Prinzipdarstellung verschiedener Funktionsblöcke eines erfindungsgemäßen Elektronikmoduls 1 und ihre Verbindung miteinander. Das Elektronikmodul 1 ist zur Montage an einem Elektromotor, insbesondere an einer axialen Stirnseite eines Elektromotor 40 vorgesehen, der in Fig. 2 dargestellt ist. Der Elektromotor 40 treibt eine nicht dargestellte Kreiselpumpe an, beispielsweise eine solche einer Heizungsanlage, Kühlungsanlage, einer Trinkwasserversorgung, Brauchwassererwärmungsanlage etc.

Das Elektronikmodul 1 umfasst eine in einem Gehäuse 2, 3 angeordnete Elektronik 10, 20 zur Steuerung und/ oder Regelung des Elektromotors 40, die aus den Hauptfunktionsgruppen Motorsteuereinheit 10 und Systemsteuereinheit 20 gebildet ist. Die Motorsteuereinheit 10 umfasst leistungselektronische Bauelemente 15 eines Drehzahlstellers, beispielsweise eines Frequenzumrichters mit Spannungszwischenkreis, die auf einer ersten gedruckten Leiterplatte 10a angeordnet sind. Die Motorsteuereinheit 10 ist über eine elektrische Verbindung 46 mit den Wicklungen des Elektromotors 40 verbunden und versorgt diese mit elektrischer Leistung. Die Systemeinheit 10 umfasst systemelektronische Bauelemente 25, beispielsweise einen oder mehrere Mikroprozessoren, Programm- und Datenspeicher (RAM, ROM), Messsignalauswertung und/ oder Verarbeitung, Schnittstellencontroller usw., die auf einer zweiten gedruckten Leiterplatte 20a angeordnet sind. Sie bildet somit das intelligente Zentrum der Elektronikmoduls 1 und führt Regelungs-, insbesondere Pumpenregelungs-, Berechnungs-, Speicher- und/ oder Analyse- (Monitoring, Fehlererkennung) sowie Kommunikationsaufgaben durch. Die Systemsteuereinheit 20 ist steuerungstechnisch mit der Motorsteuereinheit 10 über eine elektrische Verbindung 45 (Kabel) verbunden und steuert diese an, beispielsweise durch Vorgabe einer Solldrehzahl, damit sie einen bestimmten Betriebspunkt am Elektromotor 40 respektive der Kreiselpumpe einstellt. Überwiegend sind die systemelektronischen Bauelemente 25 in SMD-Technik ausgeführt.

Die Systemsteuereinheit 20 weist elektrische Kontakte 8a, 8b, 8c, 8d, 8e auf, die jeweils als Steck-, Schraub- oder Klemmanschlüsse ausgeführt sein können und gemeinsam einen Anschlussbereich 8 bilden. An diese Kontakte 8a, 8b, 8c, 8d, 8e können verschiedene externe Geräte, beispielsweise Sensoren, Aktoren und/ oder Meldeleitungen einer Gebäudeautomation angeschlossen werden. So kann beispielsweise ein erster Kontakt 8a einen digitalen Eingang bilden, an welchen z.B. ein externes Schaltelement anschließbar ist. Ein zweiter Kontakt 8b kann einen anlogen Eingang bilden, beispielsweise für einen Differenzdrucksensor oder einen Temperatursensor. Ein dritter Kontakt 8c kann eine Busschnittstelle für eine standardisierte oder proprietäre Kommunikation über einen 2, 3 oder mehradrigen Bus mit einem anderen Gerät, beispielsweise einer übergeordneten Zentralsteuerung oder mit einer anderen Pumpe oder Pumpen im Rahmen eines Doppelpumpen- oder Multipumpenbetriebs bilden. Zudem können ein oder mehrere potentialfreie Kontakte 8d, 8e vorhanden sein, die als Öffner oder Schließer ausgebildet sind und einen betriebszustandsabhängigen Status des Elektromotors oder der Pumpe nach außen melden. Diese Kontakte 8d, 8e dienen insbesondere dem Anschluss an eine Gebäudeautomation. So kann ein Kontakt 8d beispielsweise eine Sammelstörmeldung (SSM) ausgeben und beispielsweise geschlossen sein, wenn die Pumpe stromlos ist oder keine Störung vorliegt. Dies realisiert einen potentialfreien Öffner. Zusätzlich oder alternativ kann ein Kontakt 8e eine Sammelbetriebsmeldung (SBM) ausgeben und beispielsweise geschlossen sein, wenn die Pumpe bestromt ist. Dies realisiert einen potentialfreien Schließer. Diese Meldekontakte können Ausgänge von Relais bilden.

Das Elektronikmodul 1 umfasst ferner eine Anzeige- und/ oder Bedieneinheit 30 zur Einstellung des Elektromotors 40 respektive der Kreiselpumpe und zur Darstellung von Informationen. Je nach Ausstattung können hierfür ein oder mehrere Bedienelemente 35, 36, 37 zur Interaktion mit dem Elektronikmodul 1 einerseits und/ oder eine beliebige Anzeige 32 wie eine einfache LED-Segmentanzeige bis hin zu einem grafischen Farbdisplay vorhanden sein. Das Display 32 kann auch berührungssensitiv (Touchdisplay) sein, so dass es die Funktionalität einer Anzeige und einer Bedieneinheit in sich vereinigt. Die Anzeige 32 ermöglicht die Darstellung von Informationen über den Betriebszustand, die Einstellung, Messwerten, Fehlern oder anderen Daten des Elektromotors 40 bzw. der Kreiselpumpe. Die Anzeige- und/ oder Bedieneinheit 30 bildet ebenfalls eine Funktionsgruppe, die elektrisch mit der Systemsteuereinheit 20 in Verbindung steht. Sie stellt ein Mensch-Maschine Interface (HMI) dar und ist bevorzugt frei von das Elektronikmodul 1 individualisierenden Daten. Es kann somit abgenommen und durch eine andere Anzeige- und/ oder Bedieneinheit 30 ersetzt werden, ohne dass es einer Programmierung respektive einer datentechnischen Anpassung dieser anderen Anzeige- und/ oder Bedieneinheit 30 an das zu bedienende Elektronikmodul 1 bedürfte. Die Anzeige- und/ oder Bedieneinheit 30 ist über eine elektrische Verbindung 47 mit der zweiten Leiterplatte 20a verbunden.

Als weitere Funktionseinheiten sind in Figur 1 ein Interfacemodul 62 und eine Schnittstelleneinheit 16 vorhanden. Das Interfacemodul 62 ist optional und stellt eine oder mehrere Kommunikationsschnittstellen nach einem bekannten Standard bereit, beispielsweise eine oder mehrere Bus-Schnittstellen (CAN, LON, PLR, RS485, Ethernet etc.) und/ oder eine oder mehrere Funkschnittstellen (Infrarot, Bluetooth®, WLAN, EnOcean®). Die Schnittstelleneinheit 16 ist durch ein von der ersten und zweiten Leiterplatte 10a, 20a unabhängiges Trägerelement 18 gebildet, auf dem in dem in den Figuren gezeigten Ausführungsbeispiel drei Schnittstellen 17, 27, 28 ausgebildet sind. An die erste Schnittstelle 17 kann bestimmungsgemäß ein Netzstecker 60 angeschlossen werden, der das Elektronikmodul 1 mit einer elektrischen Spannung, beispielsweise 230V versorgt. Die erste Schnittstelle 17 ist elektrisch mit der Motorsteuereinheit 10 verbunden und überträgt somit elektrische Leistung. An einer zweiten Schnittstelle 27 kann beispielsweise ein externer Sensor 61, beispielsweise ein Volumenstromsensor, angeschlossen werden. An einer dritten Schnittstelle 28 kann ein weiteres Elektronikmodul angeschlossen werden, das mitsamt der Kreiselpumpe des Elektronikmoduls 1 ein Doppelpumpenaggregat oder Multipumpenaggregat bildet. Die zweite und dritte Schnittstelle 27, 28 sind elektrisch mit der Systemsteuereinheit 20 verbunden. Über sie wird keine wesentliche elektrische Leistung übertragen, vielmehr werden hier Daten übertragen.

Anhand von Figur 1 wird die erfindungsgemäße Grundidee deutlich, die Elektronik 10, 20 des Elektronikmoduls 1 derart aufzuteilen, dass eine erste Funktionseinheit, nämlich die Systemelektronik 20, nur für den Menschen ungefährliche Spannungen verarbeitet, die zweite Leiterplatte 20a mithin also nur Kleinspannungen (Niederspannungen) trägt, wohingegen eine zweite Funktionseinheit, nämlich die Motorelektronik 10 für den Menschen schädliche Betriebsspannungen, insbesondere die Netzspannung (110V, 230V, 400V) führt, die erste Leiterplatte 10a mithin also höhere Betriebsspannungen führt. Dies ist durch eine entsprechende Musterung der Funktionseinheiten in Fig. 1 veranschaulicht. Die Motorsteuereinheit 10, der Elektromotor 40, der Netzstecker 60 sowie die entsprechende Schnittstelle 17 für den Netzstecker 60 der Schnittstelleneinheit 16 sind einer ersten Spannungsebene zugeordnet, die die höheren Betriebsspannungen (110V, 230V, 400V) umfasst. Die Systemsteuereinheit 20, die Anzeige- und/ oder Bedieneinheit 30, das optionale Interface-Modul 62 sowie der externe Sensor 61 samt der entsprechenden Schnittstelle 28 sowie auch die weitere Schnittstelle 27 sind der zweiten Spannungsebene zugeordnet, die nur Kleinspannungen (SELV, PELV) unter 25V umfasst. Eine Ausnahme können die potentialfreien Meldekontakte 8d, 8e des Anschlussbereichs 8 bilden. Hier kann bedarfsweise durch den Installateur eine externe Schaltspannung zwischen 12V und 240V angeschlossen werden. Werksseitig sind diese Meldekontakte weder der ersten noch der zweiten Spannungsebene zugeordnet.

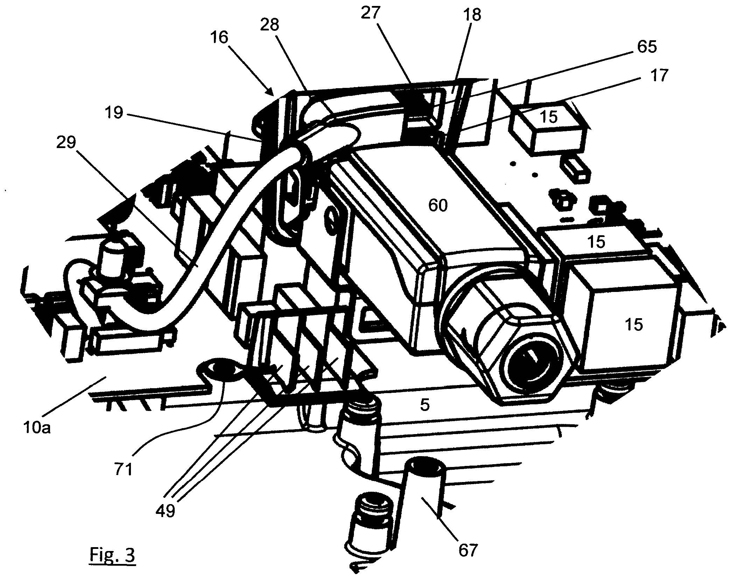

Figur 2 zeigt eine Explosionsdarstellung eines erfindungsgemäßen Elektronikmoduls 1, das die wesentlichen Funktionseinheiten aus Fig 1 umfasst. Es wird hier deutlich, dass das Elektronikmodul 1 an die axiale Stirnseite des Elektromotors 40 montiert wird, wobei jedoch gemäß einer anderen Ausführungsvariante auch eine Montage radial an einem Elektromotor 40 möglich ist. Figuren 3 bis 5 zeigen vergrößerte Ausschnitte der Explosionsdarstellung aus Fig. 2.

Die Elektronik 10, 20 ist in einem ein Unterteil 2 und ein Oberteil 3 umfassendes Gehäuse 2, 3 aufgenommen, wobei in dem Unterteil 2 ein erster Raumbereich 5 und in dem Oberteil 3 ein zweiter Raumbereich 6 vorhanden ist, welche durch eine Trennwand 50 voneinander getrennt sind. Die Trennwand 50 bildet ein separates Bauteil. In dem ersten Raumbereich 5 liegt eine erste Leiterplatte 10a mit leistungselektronischen Bauelementen 15, 15a der Motorsteuereinheit 10 zur Speisung des Elektromotors 40 ein, die Betriebsspannungen der ersten Spannungsebene trägt. Die erste Leiterplatte 10a ist im Unterteil 2 verschraubt. Sie kann alternativ verrastet sein. In dem zweiten Raumbereich 6 liegt eine zweite Leiterplatte 20a mit systemelektronischen Bauelementen 25 einer Systemsteuereinheit 20 ein, die Betriebsspannungen der zweiten, niedrigeren Spannungsebene trägt, die insbesondere Spannungen (SELV, PELV) von weniger als 25V umfasst.

Der erste Raumbereich 5 mitsamt der ersten Leiterplatte 10a, die Trennwand 50 und der zweite Raumbereich 6 mitsamt der zweiten Leiterplatte 20a sind axial übereinander angeordnet. Somit sind die Bauteile der ersten Spannungsebene, die eine für den Menschen schädliche Spannung tragen oder führen, geschützt und unzugänglich für den Installateur im unteren Raumbereich 5 verborgen. Die Trennwand 50 bildet hier eine elektrische, aber auch gleichzeitig einer thermischen Isolation.

In dem Oberteil 3 ist des Weiteren ein axial über dem zweiten Raumbereich 6 liegender dritter Raumbereich 7 ausgebildet, der einen Anschlussraum zum Anschließen von Kabeln darstellt. In diesen ragen die elektrische Kontakte 8a-8e des Anschlussbereichs 8 der zweiten Leiterplatte 20a in Gestalt von Anschlussklemmen 26 durch entsprechende Öffnungen in einem Boden 22 des Oberteils 3 hinein. Der Boden 22 deckt die zweite Leiterplatte 20a im Übrigen ab, insbesondere nahezu vollständig ab, so dass auch diese für den Installateur weitestgehend unzugänglich ist, wodurch das Eintreten von Fremdkörpern (Staub, Metallspäne, Drahtstücke) in den zweiten Raumbereich 6 beim Arbeiten im Anschlussraum verhindert wird. Insbesondere sorgt auch der Boden 22 des Oberteils 3 zum einen für eine elektrische, vor allem aber auch für eine thermische Abschirmung zwischen dem zweiten und dem dritten Raumbereich 6, 7. Die elektrischen Anschlüsse 8a-8e sind hier als Klemmanschlüsse ausgebildet, um einen schnellen und leichten Anschluss der Kabel zu ermöglichen. Vorzugsweise können die Anschlussklemmen 8a-8e farblich unterschiedlich ausgebildet bzw. farblich kodiert sein, um sie unterscheiden zu können und somit die Gefahr von Verwechselungen zu vermeiden.

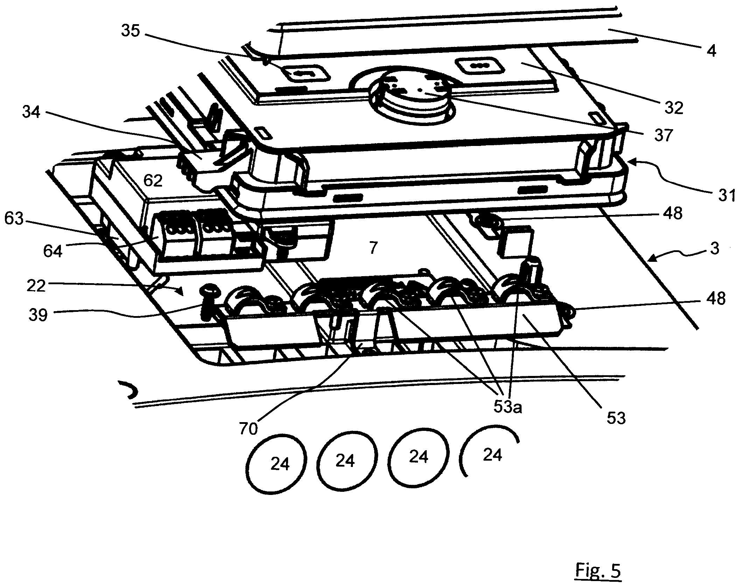

Wie insbesondere anhand von Fig. 5 erkennbar ist, liegt in dem dritten Raumbereich 7 ein Interface-Modul 62 ein, das mit einer entsprechenden Schnittstelle 63 durch eine Öffnung im Boden 22 axial mit Kontakten auf der zweiten Leiterplatte 20a gesteckt ist. Das Interface-Modul 62 ist optional und erweitert das Elektronikmodul 1 um Anschlüsse 64 zum Anschließen diverser Busse, wie z.B. CAN, LON, PLR und/ oder Ethernet. Ferner kann es auch Funkschnittstellen wie z.B. Infrarot, Bluetooth, WLAN oder EnOcean bereitstellen, um das Elektronikmodul 1 lokal mittels Punkt-zu-Punkt Verbindung anzusteuern oder es in ein bestehendes Netzwerk zu integrieren.

Auf dem Oberteil 3 ist dann die den dritten Raumbereich 7 abdeckende Anzeige- und/ oder Bedieneinheit 30 abnehmbar aufgesetzt ist. Diese deckt das Oberteil 3 nicht vollflächig ab, sondern nur den nach oben offenen dritten Raumbereich 7, der wie eine wannenförmige Vertiefung in der axialen Stirnseite des Oberteils 3 gestaltet ist, so dass der diese Vertiefung umgebende Bereich der Stirnseite des Oberteils 3 eine Außenfläche des Elektronikmoduls 1 bildet. Die Anzeige- und/ oder Bedieneinheit 30 bildet somit keinen Deckel des gesamten Elektronikmoduls 1 und ist auch nicht in einen solchen Deckel integriert. Sie bildet vielmehr ein separates Modul, dessen laterale Abmessungen kleiner sind als die des Oberteils 3, und das lediglich eine Abdeckung für einen Teil des Oberteils 3 darstellt.

Die Anzeige- und/ oder Bedieneinheit 30 besteht aus einer eingehausten Elektronik 31 und einer Bedienfeldabdeckung 4 in der Art einer Blende, die außen auf die Elektronik 31 aufgesetzt ist und diese an den Seiten überragt, so dass sie im montierten Zustand auch das Oberteil 3 teilweise abdeckt. Mit anderen Worten ist die Elektronik 31 unterseitig an der Blende 4 angeordnet, insbesondere mit dieser verrastet. Im montierten Zustand liegt die Elektronik 31 in dem dritten Raumbereich 7 ein. An der zum dritten Raumbereich 7 gerichteten Unterseite des Gehäuses der Elektronik 31 ist eine umlaufende Dichtung angeformt, insbesondere angespritzt, welche im montierten Zustand der Anzeige- und/ oder Bedieneinheit 30 mit einer im Oberteil 3 ausgebildeten Stufe in Kontakt steht, um den dritten Raumbereich 7 abzudichten. Die Blende 4 besitzt einen Seitenschenkel 4a, mit dem sie das Oberteil 3 seitlich umgreift. Im Querschnitt betrachtet, ist die Blende 4 somit im Wesentlichen L-förmig.

Die Elektronik 31 besitzt in der Ausführungsvariante gemäß Fig. 2 ein grafisches Display 32, insbesondere ein Farbdisplay zur Darstellung von Informationen und/ oder Grafiken. Des Weiteren umfasst es Bedienelemente 35, 37 in Gestalt von zwei Drucktasten 35, die symmetrisch unterhalb des Displays 32 angeordnet sind, sowie ein drehbares, insbesondere dreh-drückbares elektrisches Eingabeelement 37, das unterhalb der Drucktasten 35 mittig angeordnet ist und einen Bedienknopf 36 trägt. Das Eingabeelement 37 kann zusätzlich oder alternativ eine Navigationsfunktion (Joystick) aufweisen, d.h. in die vier Himmelsrichtungen bewegbar sein, um in Menüs der Software der Systemelektronik 20 zu navigieren. Das Eingabeelement 37 kann im einfachsten Fall ein Potentiometer, bevorzugt aber ein Impulsgeber, ein Multifunktionselement oder ähnliches sein, dessen elektrischer Teil 37 in der Elektronik 31 untergebracht ist und dessen mechanischer Teil aus dieser hervorsteht, sich zumindest teilweise durch eine Öffnung in der Blende 4 hindurcherstreckt, und jenseits der Blende 4 den aufgesetzten, hier tortenförmigen Bedienknopf 36 trägt. Die Blende 4 weist in ihrem unmittelbar über dem Display 32 liegenden Bereich ein klares Sichtfenster 33 auf, das das Display 32 abdeckt und schützt.

Die Montage der Anzeige- und/ oder Bedieneinheit 30 kann derart erfolgen, dass es mit Haltezungen 34 bildenden Vorsprüngen, siehe Fig. 5, in korrespondierende Vertiefungen an einer Innenseite des dritten Raumbereichs 7 schräg zum Boden 22 des Oberteils 3 eingesetzt und mitsamt der Blende 4 dann nach unten geschwenkt wird, wobei die Lagerung der Vorsprünge in den Ausnehmungen eine Schwenkachse bildet. Mittels Schrauben 38, die vorzugsweise als unverlierbare Maschinenschrauben ausgestaltet sind, kann die Anzeige- und/ oder Bedieneinheit 30 anschließend am Oberteil 3 befestigt werden. Hierzu werden die Schrauben 38 in zylindrische Schraubenaufnahmen 48 eingeschraubt. Die Schraubenaufnahmen 48 besitzen ein entsprechendes Innengewinde, sind aus Messung und liegen in zylindrischen Vertiefungen des Oberteils 3 ein. Um an die elektrischen Kontakte 8a-8e zu gelangen bzw. diese mit entsprechenden Leitungen zu verbinden, kann die Demontage der Anzeige- und/ oder Bedieneinheit 30 in entsprechend umgekehrter Reihenfolge erfolgen.

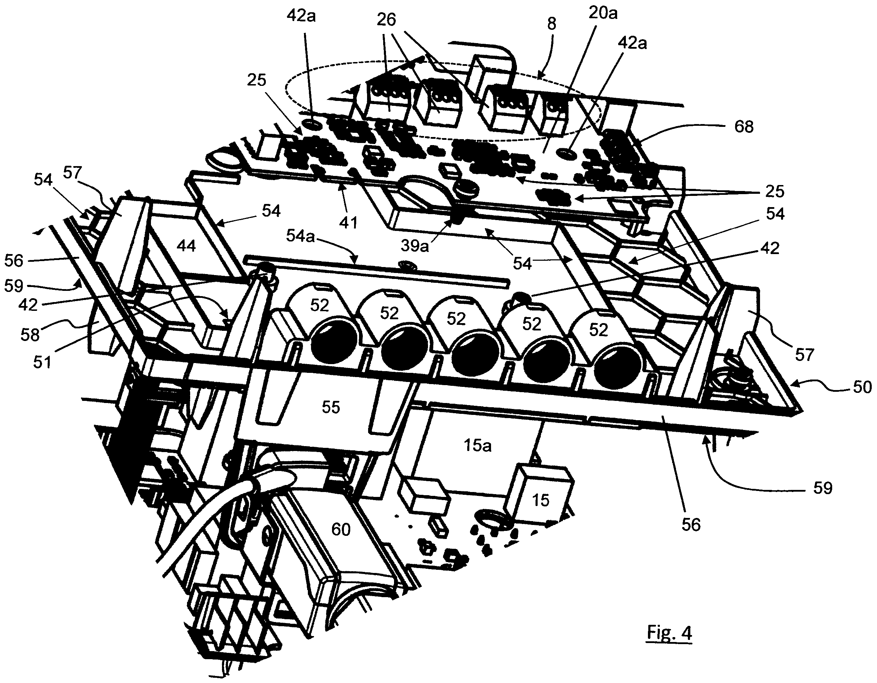

Die elektrische Verbindung 47 der Anzeige- und/ oder Bedieneinheit 30 mit der zweiten Leiterplatte 20a erfolgt über eine zweifache Federkontaktierung und wird automatisch hergestellt, wenn die Anzeige- und/ oder Bedieneinheit 30 auf das Oberteil 3 geklappt wird. Die zweifache Federkontaktierung besteht aus einer ersten Gruppe von Kontaktfedern 68 (Fig. 4), die auf der zweiten Leiterplatte 20a angeordnet sind, einer Gruppe länglicher Brückenkontakte, die durch das Oberteil 3 hindurchgeführt sind, und einer zweiten Gruppe von Kontaktfedern, die an der Anzeige- und/ oder Bedieneinheit 30 vorhanden sind. Die Anzahl der Kontaktfedern 68 der ersten Gruppe, die Anzahl der Brückenkontakte und die Anzahl der Kontaktfedern der zweiten Gruppe ist identisch. Wie Fig. 4 entnommen werden kann, ist die Anzahl vier. Allerdings können in einer anderen Ausführungsvariante die Anzahlen der Kontaktfedern 68 der ersten Gruppe, der Brückenkontakte und der Kontaktfedern der zweiten Gruppe auch unterschiedlich sein.

Die Kontaktfedern 68 der ersten Gruppe ragen zum Oberteil 3 hin und werden jeweils von einem Ende eines der Brückenkontakte federnd kontaktiert. Die Kontaktfedern 68 sind in Gestalt von im Wesentlichen Z-förmig gebogener Bleche ausgeführt und werden durch Druck aus Richtung des Oberteils 3 gestaucht. Die Bleche können aber auch beliebig anders geformt sein, um eine Federwirkung zu entfalten. Die Brückenkontakte sind in Gestalt von Flachkontakten ausgebildet und fest im Oberteil gehalten. Dies kann beispielsweise durch Umspritzen der Kontakte oder durch kraftschlüssiges Einstecken der Brückenkontakte in entsprechende Öffnungen im Oberteil erfolgen. Im mittleren Bereich können die Brückenkontakte jeweils eine Verdickung aufweisen, die einen besseren Halt im Oberteil gewährt und/ oder im Falle des Einschiebens der Brückenkontakte einen Anschlag bildet, so dass alle Brückenkontakte identisch weit in das Oberteil eingeschoben bzw. zueinander ausgerichtet sind. Die Brückenkontakte ragen auf der dem zweiten Raumbereich 6 gegenüberliegenden Seite des Oberteils 3 hervor, um mit ihrem anderen Ende jeweils eine Kontaktfeder der zweiten Gruppe zu kontaktieren. Die Kontaktfedern der zweiten Gruppe sind identisch zu den Kontaktfedern 68 der ersten Gruppe ausgeführt. Die Kontaktfedern 68 und/ oder die Brückenkontakte können vergoldet sein, um eine Oxidation zu vermeiden.

Eine besondere Eigenschaft des erfindungsgemäßen Elektronikmoduls ist es, dass die Anzeige- und/ oder Bedieneinheit 30 im Betrieb des Elektromotors abgenommen werden kann, ohne den Betrieb zu unterbrechen (Hot Swapping). Der Elektromotor 40 bzw. die von ihm angetriebene Kreiselpumpe läuft gemäß der vorgenommenen Einstellung unverändert weiter. Dies ermöglicht einen problemlosen und schnellen Austausch der Anzeige- und/ oder Bedieneinheit 30, sollte diese mal einen Defekt aufweisen. Unter anderem ist ein folgenloses Abnehmen der Anzeige- und/ oder Bedieneinheit 30 deshalb möglich, weil sie keine Betriebsinformationen, insbesondere keine Regelungsparameter enthält. Diese Daten sind ausschließlich in der Systemsteuereinheit 20 vorhanden. Die Anzeige- und/ oder Bedieneinheit 30 dient somit lediglich der Bekanntgabe und der Eingabe von Daten. Wird die Anzeige- und/ oder Bedieneinheit 30 getauscht, so übernimmt die neue Anzeige- und/ oder Bedieneinheit 30 nahtlos die Aufgabe der vorherigen Anzeige- und/ oder Bedieneinheit 30, so dass keine Konfiguration, keine Datenübertragung und auch keine sonstige Maßnahme erforderlich ist, um die neue Anzeige- und/ oder Bedieneinheit 30in Betrieb zu nehmen.

Wird die Anzeige- und/ oder Bedieneinheit 30 abgenommen, so erfolgt unmittelbar automatisch eine Versiegelung der elektrischen Kontakte, die die Anzeige- und/ oder Bedieneinheit 30 kontaktierten. Obgleich im Anschlussraum bzw. dritten Raumbereich 7 ohnehin nur Kleinspannungen von der zweiten Leiterplatte 20a zur Verfügung gestellt sind, werden die elektrischen Kontakte zur Anzeige- und/ oder Bedieneinheit 30 zusätzlich "tot gelegt", damit der Installateur sicher sein kann, dass von diesen, nach Abnahme der Anzeige- und/ oder Bedieneinheit 30 offenen Kontakten keine Gefahr ausgeht. Gleichzeitig hat diese Versieglung die Aufgabe, die Kontakte von bestimmten systemelektronischen Bauteilen 25 zu trennen, so dass ein Kurzschließen der Kontakte zu keinem Schaden an der Systemsteuereinheit 20 führt.

Die Trennwand 50 bildet ein zum Oberteil 3 und Unterteil 2 separates Bauteil, das das zum Unterteil 2 hin offene Oberteil 3, uns in Konsequenz daraus auch das zum Oberteil 3 offene Unterteil 2 verschließt. Es bildet einen Zwischenboden und dient der elektrischen und thermischen Isolation. Zu diesem Zweck ist es aus Kunststoff spritzgegossen. Um hier den Fügeprozess zu erleichtern, sind an der zum Oberteil 3 gerichteten Seite der Trennwand 50 mehrere über den Umfang verteilte obere Führungsdome 57 randseitig angeformt. Diese haben im Querschnitt betrachtet im Wesentlichen eine T-Form, deren Mittelschenkel zum Rand gerichtet ist. Zum distalen Ende werden die Mittelschenkel zunehmend kürzer, so dass zu Beginn des axialen Zusammenführens von Oberteil 3 und Trennwand 50 ein Spiel zwischen den Führungsdomen 57 und der Innenseite der Seitenwände des Oberteils 3 besteht, das mit zunehmendem Zusammenführen immer weniger wird.

Um die Montage der Trennwand 50 auf dem Unterteil 2 zu erleichtern, sind an der zum Unterteil 2 gerichteten Seite mehrere, über den Umfang verteilte untere Führungsdome 58 randseitig angeformt. Diese haben im Querschnitt betrachtet ebenfalls im Wesentlichen eine T-Form, deren Mittelschenkel zum Rand gerichtet ist. Zum distalen Ende werden die Mittelschenkel auch hier zunehmend kürzer, so dass zu Beginn des axialen Einführens der Führungsdome 58 in das Unterteil 2 ein Spiel zwischen den Führungsdomen 58 und der Innenseite der Seitenwände des Unterteils 3 besteht, das mit zunehmendem axialen Einführen immer weniger wird.

Auch die Seitenschenkel der oberen und/ oder unteren Führungsdome 57, 58 könne zum distalen Ende hin zunehmend schmaler werden, um Material einzusparen und eine Verletzung infolge vorstehender Ecken zu vermeiden. Die Führungsdome 57, 58 können gleichzeitig als Abstandshalter dienen, wobei der Abstand zur die Länge bzw. Höhe der Dome festgelegt ist.

In der Trennwand 50 ist eine, hier beispielhaft rechteckige Öffnung 44 ausgebildet, durch die die elektrische Verbindung 45 zwischen der ersten und zweiten Leiterplatte 10a, 20a geführt ist. Die zweite Leiterplatte 20a erstreckt sich mit einem Anschlussbereich 66 über diese Öffnung 44 hinaus, wobei der Anschlussbereich 66 durch Oberflächenkontakte ober- und/ oder unterseitig auf der zweiten Leiterplatte 20a gebildet ist, die mittels eines Platinenrandsteckers der elektrischen Verbindung 45 kontaktiert werden können.

Unabhängig von dieser Kontaktierung erstreckt sich die zweite Leiterplatte 20a mit einem anderen Teilbereich über die Öffnung 44 hinaus. Auf diesem Teilbereich ist eine Bluetooth-Antenne 72 angeordnet. Diese Platzierung hat den Vorteil, dass zu allen Seiten der Bluetooth-Antenne 72 ein ausreichender Abstand zu Teilen aus Metall und Kunststoff gegeben ist, so dass die Bluetooth-Antenne 72 elektromagnetische Wellen bestmöglich abstrahlen und empfangen kann. Wie zudem in Fig. 2 erkennbar ist, erstreckt sich der dritte Raumbereich 7 im Oberteil 7 nicht bis über die Bluetooth-Antenne 72. Vielmehr liegt oberhalb der Bluetooth®-Antenne 72 ein Hohlraum vor, der in den zweiten Raumbereich 6 übergeht. Die Bluetooth-Antenne 72 kann somit problemlos an der Anzeige- und/ oder Bedieneinheit 30 räumlich vorbeifunken.

Die Trennwand 50 weist des Weiteren an ihrer Ober- und/oder Unterseite oberflächliche Verstärkungsstrukturen 54, 54a in Gestalt sich rechtwinklig von der Oberfläche erhebender Rippen auf, die sich lateral, insbesondere längs oder quer oder auch in einer Wabengeometrie auf der Oberfläche erstrecken. Durch sie wird eine Versteifung der Trennwand 50 erreicht. Ferner dienen die Verstärkungsstrukturen der Schwingungsminimierung. Aufgrund der Verstärkungsstrukturen 54, 54a kann die Trennwand 50 ferner dünner ausgestaltet sein, wodurch das Gewicht reduziert wird. Im mittleren Bereich der Trennwand 50 ist eine Stützrippe 54a zum Ab- oder Unterstützen der zweiten Leiterplatte 20a vorhanden. Die Stützrippe 54a ist dort angeordnet, wo oberhalb der zweiten Leiterplatte 20a die Anschlussklemmen 26 der elektrischen Kontakte 8a-8e liegen. Hierdurch wird ein Durchbiegen der zweiten Leiterplatte 20a vermieden, soweit auf einer der Anschlussklemmen 26 zum Anschließen einer Leitung eine Druckkraft in Richtung der zweiten Leiterplatte 20a ausgeübt wird.

Die Trennwand 50 weist an ihrem Außenumfang einen zumindest teilweise, vorzugsweise vollständig, umlaufenden Rahmen 56 auf, der durch einen sich rechtwinklig zum zur zweiten Leiterplatte parallel liegenden Hauptbereich der Trennwand 50 erstreckenden Schenkel gebildet ist. Der Rahmen 56 erstreckt sich somit parallel zu den Seitenwänden 21 des Oberteils 3. Durch den Rahmen 56 wird zudem insgesamt eine mechanische Verstärkung und Biegesteifigkeit erreicht. Die Trennwand 50 liegt mit ihrer Unterseite auf der zum Oberteil 3 gerichteten Umfangskante 43 dichtend auf, so dass am Übergang zwischen Unter- und Oberteil 2, 3 keine Feuchtigkeit bzw. keine Flüssigkeit in den ersten Raumbereich 5 eindringen kann. Die Abdichtung erfolgt hier somit axial. Zur Abdichtung ist zwischen der Trennwand 50 und der Umfangskante 43 eine entsprechende Dichtung vorhanden. Um die Dichtung lagesicher auszubilden, ist sie direkt auf der zum Unterteil 3 gerichteten Unterseite 59 der Trennwand 50 randseitig umlaufend angeformt (ein Elastomer angespritzt). Geeigneterweise ist die Dichtung konturiert, um die Umfangskante 43 formschlüssig an zumindest einer Seite, vorzugsweise der Innenseite, zu umgreifen.

Zusätzlich weist der Rahmen 56 an seiner Außenseite eine abstehende, nach außen orientierte, umlaufende Dichtlippe auf, die im montierten Zustand des Trennelements 50 an der Innenseite der Seitenwände 21 des Oberteils 3 in dichtend anliegt, so dass am Übergang zwischen Unter- und Oberteil 2, 3 auch keine Feuchtigkeit bzw. keine Flüssigkeit in den zweiten Raumbereich 6 eindringen kann. Die Abdichtung erfolgt hier somit radial. Um die Dichtung lagesicher auszubilden, kann sie ebenfalls direkt an der Trennwand 50 bzw. an dem Rahmen 56 angeformt (ein Elastomer angespritzt) sein.

Idealerweise erstreckt sich die Dichtlippe von der Außenseite des Rahmens 56 schräg in Richtung Unterteil 2. Dies bewirkt, dass das Einsetzen der Trennwand 50 in das Oberteil unter Überwindung eines geringeren Reibwiderstands erfolgt, als das Herausnehmen der Trennwand 50 aus dem Oberteil 3 zur Folge hat. Die Dichtwirkung der Dichtlippe wird dadurch erhöht.

Durch die außen am Rahmen 56 angeformte Dichtlippe und die unterseitig an der Trennwand 50 angeformte Dichtung wird die Schutzklasse IP 44 erreicht. Dichtlippe und Dichtung gehen ferner ineinander über und bilden somit eine stoffschlüssige Einheit, so dass zur Ausbildung beider Dichtungen nur ein Spritzgießschritt erforderlich ist.

Wie des Weiteren aus Fig. 4 erkennbar ist, weist die Trennwand 50 eine Anzahl nebeneinanderliegender hohlzylindrischer Geometrien 52, die randseitig angeordnet sind. Sie dienen einerseits als Kabelführung 52 und fluchten im montierten Zustand der Trennwand 50 mit Öffnungen 24, die in einer Seitenwand 21 des Oberteils 3 vorgesehen sind. Andererseits weisen die hohlzylindrischen Geometrien 52 Innengewinde zum Einschrauben sogenannte PG-Verschraubungen auf, die ein Kabel knicksicher in das Elektronikmodul 1 leiten. Aus Sicht dieser Öffnungen 24 rückseitig der Kabelführungen 52 sind im dritten Raumbereich 7 bügelartige Kabelbefestigungen 53a einer metallischen Schirmauflage 53 vorhanden, um den Schirm eines durch eine Öffnungen 24 und die entsprechende Kabelführung 52 hindurchgeführten Kabels zu erden.

Die Trennwand 50 weist des Weiteren eine haubenartige Ausformung in einem Bereich auf, der mit einem entsprechenden Bereich auf der ersten Leiterplatte 10a fluchtet, auf welchem die höchsten Bauelementen 15a angeordnet sind, so dass sich diese höchsten Bauelemente 10a, beispielsweise ein Kondensator und/ oder eine Drossel, in die haubenartige Ausformung hineinerstrecken. Auf der gegenüberliegenden Seite erstreckt sich die haubenartige Ausformung in den zweiten Raumbereich 6 hinein. Die zweite Leiterplatte 20a hat im Bereich der haubenartigen Ausformung eine Ausklinkung. Die haubenartige Ausformung hat den Vorteil, dass die Trennwand 50 näher an der ersten Leiterplatte 10a angeordnet werden kann und somit die axiale Baulänge des Elektronikmoduls 1 insgesamt verkürzt wird.

Das Elektronikmodul 1 in Fig. 1 umfasst eine Schnittstelleneinheit 16, die vergrößert in Fig. 3 dargestellt ist. Die Schnittstelleneinheit 16 ist von der ersten und zweiten Leiterplatte 10a, 20a räumlich unabhängig. Sie ist durch ein Trägerelement 18 gebildet, das Schnittstellen 17, 27, 28, hier drei an der Zahl, bereitstellt. In einer anderen Ausführungsvariante können aber auch mehr oder weniger Schnittstellen vorhanden sein. Das Trägerelement 18 ist ein Kunststoffformteil. Wie in Fig. 3 erkennbar ist, ist an einer ersten Schnittstelle 17 ein Netzstecker 60 und an einer zweiten Schnittstelle 28 ein Stecker eines Sensorkabels 29 angeschlossen. Hier kann somit ein externer Sensor 61, wie der Volumenstromsensor 61 in Fig. 1, angeschlossen werden. Die dritte Schnittstelle 27 ist unkontaktiert. Hier kann ein Elektronikmodul 1 eines anderen Pumpenaggregats für eine Doppelpumpen- oder Multipumpenanwendung angeschlossen werden.

Es sei an dieser Stelle angemerkt, dass als Schnittstelle in Bezug auf die Schnittstelleneinheit 16 hinsichtlich der Funktionalität nicht nur eine elektrische oder elektrisch-mechanische, sondern auch eine rein mechanische Schnittstelle zu verstehen ist, die von der Schnittstelleneinheit 16 bereitgestellt wird.

Denn die erfindungsgemäße Schnittstelleneinheit 16 ist, unabhängig von den übrigen Komponenten des Elektronikmoduls 1 betrachtet, so ausgestaltet, dass die zweite und dritte Schnittstelle 27, 28 jeweils elektrisch-mechanische Schnittstellen sind. Das bedeutet, dass die Schnittstelleneinheit 16 hier einerseits elektrische Kontakte besitzt, die mit dem Trägerelement 18 fest verbunden sind, und andererseits das Trägerelement 18 um diese Kontakte herum eine Kontur aufweist, um einen die Kontakte kontaktierenden Stecker oder eine Buchse formschlüssig aufzunehmen und dadurch mechanisch zu führen bzw. halten. Demgegenüber ist die von der Schnittstelleneinheit 16 bereitgestellte erste Schnittstelle 17 nur eine rein mechanische Schnittstelle, durch die ein Aufnahmeraum zur formschlüssigen Aufnahme des Netzstecker 60 zur Verfügung gestellt wird. Das bedeutet, dass die Schnittstelleneinheit 16, unabhängig von den übrigen Komponenten des Elektronikmoduls 1 betrachtet, hier keine eigenen elektrischen Kontakte bereitstellt. Zur ersten Schnittstelle 17 gehörende elektrische Kontakte 49 sind jedoch auf der ersten Leiterplatte 10a vorhanden und ragen im montierten Zustand der Schnittstelleneinheit 16 durch entsprechende Öffnungen in den Aufnahmeraum hinein. Somit besteht die erste Schnittstelle 17 aus zwei funktionalen Teilen, nämlich einem mechanischen Teil und einem elektrischen Teil, die erst durch die Montage der Schnittstelleneinheit 16 gemeinsam zu einer elektrisch-mechanischen Schnittstelle führen. Im montierten Zustand bietet die Schnittstelleneinheit gleichwohl drei elektrisch-mechanische Schnittstellen 17, 27, 28 zum Anschließen eines Steckers oder einer Buchse.

Bei der zweiten und dritten Schnittstelle 27, 28 sind demgegenüber der jeweilige elektrische und mechanische Teil als eine Einheit am Trägerelement 18 ausgebildet. Die elektrischen Kontakte sind hier jeweils als Öberflächenkontakte einer Leiterplatte 65 ausgebildet, die sich von der Rückseite des Trägerelements 18 durch eine Öffnung in einen Aufnahmeraum der ersten und zweiten Schnittstelle 27, 28 hinein erstreckt. Die Kontaktierung dieser Oberflächenkontakte erfolgt in der Art von sogenannten Platinenrandsteckern, die die Leiterplatte 65 an ihrem Rand beidseitig umgreifen. Um die Anzahl der Bauteile zu reduzieren, sind die Öberflächenkontakte der zweiten Schnittstelle 27 und die Oberflächenkontakte der dritten Schnittstelle 27 auf einer gemeinsamen Leiterplatte 65 ausgebildet. Die Leiterplatte 65 ist formschlüssig und/ oder mittels Rastelementen an dem Trägerelement 18 gehalten. Auf der Leiterplatte 65 sind keine elektrischen Bauteile vorhanden. Vielmehr sind die Oberflächenkontakte der zweiten und dritten Schnittstelle auf der Leiterplatte 65 ober- und/ oder unterseitig lediglich nach hinten, d.h. in Richtung erster Raumbereich 5, geführt, wo sie ebenfalls kontaktiert, insbesondere steckkontaktiert werden können, beispielsweise ebenfalls mittels einem gemeinsamen Platinenrandstecker oder zwei einzelnen Platinenrandsteckern. Somit besteht die Schnittstelleneinheit 16 in der hier dargestellten Ausführungsvariante nur aus dem Trägerelement 18 und der Leiterplatte 65

Im montierten Zustand ist die erste Schnittstelle 17 der ersten Spannungsebene zugeordnet und dient dem Anschluss des Elektromotors 40 an eine Netzspannung. Die zweite und dritte Schnittstelle 27, 28 ist jeweils der zweiten Spannungsebene zugeordnet und dient primär der Datenübertragung, wobei aber auch eine Niederspannungsversorgung des angeschlossenen Geräts, beispielsweise eines Sensors, über diese Schnittstellen 27, 28 erfolgen kann.

Die Zuordnung der ersten Schnittstelle 17 zur ersten Spannungsebene ist dadurch gegeben, dass deren elektrische Kontakte 49 elektrisch mit der ersten Leiterplatte 10a verbunden sind und im Betrieb Spannungen der ersten Spannungsebene führen. Die elektrischen Kontakte 49 sind in Gestalt von Flachkontakten ausgebildet, siehe Fig. 3. Sie sind randseitig auf der ersten Leiterplatte 10a angeordnet und ragen nach dem axialen Fügen der Schnittstelleneinheit 16 in den Aufnahmeraum für den Netzstecker 60 hinein, welcher zur Gegenkontaktierung entsprechende Gabelkontakte aufweist, in die die Flachkontakte 49 eingreifen können.

Insgesamt sind die elektrischen Kontakte 49 durch drei Flachkontakte zum Anschluss einer Phase (L), des Nullleiters (N) und des Schutzleiters (PE) bzw. Erde gebildet. Mit dem den Erdungskontakt bildenden Flachkontakt 49 ist seitens der ersten Leiterplatte 10a eine Anschrauböse 71 elektrisch verbunden, die bestimmungsgemäß am Unterteil 2 festgeschraubt wird, um dieses zu erden. Der Erdungskontakt der drei Flachkontakte 49 ist zudem gegenüber den anderen beiden Flachkontakten 49 in Richtung entgegengesetzt zur Ansteckrichtung des Netzsteckers 60 voreilend. D.h. die Länge des Erdungskontakts ist größer als die Länge der anderen beiden Flachkontakte 49, so dass bei einem Anstecken des Netzsteckers 60 zuerst die elektrische Verbindung mit dem Schutzleiter (PE) hergestellt wird.

Die Zuordnung der zweiten und dritten Schnittstelle 27, 28 zur ersten Spannungsebene ist dadurch gegeben, dass die zweite und dritte Schnittstelle 27, 28 jeweils mit der zweiten Leiterplatte 20a verbunden ist und nur Kleinspannungen führen. Die Verbindung erfolgt hier mittels eines gemeinsamen Flachbandkabels, das einerseits die elektrischen Kontakte der zweiten und dritten Schnittstelle 27, 28 rückseitig des Trägerelements 18 steckkontaktiert und andererseits die zweite Leiterplatte 20a kontaktiert, insbesondere steckkontaktiert. Um dieses Flachbandkabel zur Leiterplatte 20a zu führen, ist in der Trennwand 50 eine Ausnehmung 51 vorgesehen, siehe Fig. 4, durch welche das Flachbandkabel bei der Montage hindurchgeführt werden kann.

Alternativ zu einem einzigen Flachbandkabel können auch zwei einzelne Flachbandkabel verwendet werden. Auf der zweiten Leiterplatte 20a ist zum Anstecken des Flachbandkabels ein Steckbereich 41 mit Oberflächenkontakten vorgesehen, an den ein am Ende des Flachbandkabels angeordneter Platinenrandstecker ansteckbar ist. Die Ausnehmung 51 und der Steckbereich 41 sind derart angeordnet, dass der Steckbereich über der Ausnehmung 51 liegt, so dass ausreichend Platz vorhanden ist, um den Steckbereich 41 zu kontaktieren. Im montierten Zustand liegt der an den Steckbereich 41 angesteckte Platinenrandstecker in der Ausnehmung 51 ein.

Von seiner Lage ist das Trägerelement 18 rechtwinklig zu den beiden Leiterplatten 10a, 20a orientiert, so dass die Schnittstellen 17, 27, 28 in sekantialer Richtung zum Elektronikmodul 1, d.h. hier auch sekantial zur Motorachse kontaktiert werden können.

Damit die Schnittstellen 17, 27, 28 von außen frei zugänglich sind, ist in einer Seitenwand 11 des Unterteils 2 eine Seitenöffnung 13 vorhanden, in oder hinter der die Schnittstelleneinheit 16 angeordnet ist. Um ein rein axiales Fügen der Schnittstelleneinheit 16 zu gewährleisten, ist die Seitenöffnung 13 zum Oberteil 2 hin offen, erstreckt sich also bis zur Umfangskante 43 des Unterteils 2, siehe Fig. 2.

Geeigneterweise sind der Rand 19 des Trägerelements 18 und die Innenumfangskante der Seitenöffnung 13 im Unterteil 2 derart korrespondierend ausgestaltet, dass das Trägerelement 18 formschlüssig in der Seitenöffnung 13 einliegt. Am Rand 19 kann zudem eine Dichtung angeformt sein, so dass das Trägerelement 18 bzw. die Schnittstelleneinheit 19 abgedichtet in der Seitenöffnung einliegt und keine Feuchtigkeit in den Innenraum des Unterteils 2 eindringen kann.

Im Bereich der Schnittstelleneinheit 16 weist die Trennwand 50 eine Schirmwand 55 auf, die sich zum Unterteil 2 hin erstreckt. Sie erstreckt sie sich in die Seitenöffnung 13 des Unterteils 2 hinein, die sie zum Oberteil 3 hin schließt unter Freilassung desjenigen Bereichs der Seitenöffnung 13 durch den die Schnittstellen 17, 27, 28 der Schnittstelleneinheit 16 von außen zugänglich sind. Dies hat den Vorteil, dass bei verschieden hohen Unterteilen 2 unterschiedlicher Elektronikmodule 1, die Schnittstelleneinheit 16 stets identisch bleiben kann, so dass hier die Variantenvielfalt reduziert wird. Zudem dient die Schirmwand 55 zur Fixierung der Schnittstelleneinheit 16 und dichtet diese zur Trennwand 50 hin ab.

Geeigneterweise ist das Oberteil aus Kunststoff spritzgegossen, insbesondere aus einem thermisch und elektrisch isolierenden Kunststoff. Das Unterteil ist vorzugsweise im Druckguss aus Metall, insbesondere einem Leichtmetall wie Aluminium oder einer Leichtmetalllegierung hergestellt, so dass es Wärme gut aufnehmen, leiten und abgeben kann.

Im montierten Zustand des Elektronikmoduls 1 erstreckt sich dieses in radialer Richtung seitlich über den Elektromotor 40 hinaus. In diesem überstehenden Bereich sind am Unterteil 2 Kühlrippen 14 ausgebildet, die sich auf der vom Oberteil abgewandten Seite, seitlich und achsparallel zum Elektromotor 40 erstrecken. Das Unterteil 2 weist einen Boden 12 auf, in dem eine Vertiefung 12a ausgebildet ist, welche der Aufnahme des- oder derjenigen leistungselektronischen Bauteile dient, die die meiste Abwärme erzeugen. Dieses oder diese werden in wärmeleitende Verbindung mit dem Boden 12 gebracht, um die Wärme an die Kühlrippen 14 abgeben zu können. Im Bereich der Kühlrippen 14 ist die axiale Länge des Oberteils 3 größer als im übrigen Bereich, der durch einen Rücksprung 23 in der Oberteilunterkante gebildet ist.

Die Montage des erfindungsgemäßen Elektronikmoduls 1 erfolgt "Bottom Up", d.h. von unten nach oben unter axialem Fügen sämtlicher Bauteile. Dabei erfolgt zunächst das Einsetzen der ersten Leiterplatte 10a in den ersten Raumbereich 5 des Unterteils 2, wobei die erste Leiterplatte 10a am Boden 12 des Unterteils 2 mittels Schrauben befestigt wird, die durch entsprechende Bohrungen in der ersten Leiterplatte hindurchgeführt sind. Der Umfangsbereich um diese Bohrungen herum ist metallisiert, so dass durch die Verschraubung das Erdpotenzial auf die erste Leiterplatte 10a gebracht ist. Anschließend wird die Schnittstelleneinheit 16 samt daran angeschlossenem Flachbandkabel in die Seitenöffnung 13 des Unterteils 2 eingesetzt. Auch diese wird anschließend mit dem Unterteil 2 verschraubt. Danach wird die Trennwand 50 auf das Unterteil 2 aufgesetzt, so dass der erste Raumbereich 5 abgedeckt ist. Die unteren Führungsdome 58 helfen dabei, die Trennwand 50 zum Unterteil 2 derart auszurichten, dass der unterseitige Rand der Trennwand 50 vollumfänglich auf der Umfangskante 43 des Unterteils 2 zu liegen kommt. Währen des Aufsetzens der Trennwand 50 wird das Flachbandkabel der Schnittstelleneinheit 16 durch die Ausnehmung 51 und das Platinenverbindungskabel 45 durch die Öffnung 44 in der Trennwand 50 gesteckt.

Es folgt nun eine Teilmontage der zweiten Leiterplatte 20a auf der Trennwand 50. Die zueinander gerichteten Innenflächen der oberen Führungsdome 27 dienen hierbei als axiale Führung. Eine Vorpositionierung der zweiten Leiterplatte 20a wird durch wenigstens ein Rastelement erreicht, das die zweite Leiterplatte 20a umgreift und vor dem Herausfallen schützt. Vor oder nach der Verrastung der zweiten Leiterplatte 20a werden das Flachbandkabel der Schnittstelleneinheit 16 und das Platinenverbindungskabel 45 über den jeweiligen Platinenrandstecker mit der zweiten Leiterplatte 20a verbunden.

Nach dem Einsetzen der zweiten Leiterplatte 20a wird das Oberteil 3 auf die Trennwand 50 aufgesetzt. Die Außenseiten der oberen Führungsdome 27 dienen hierbei als axiale Führung. Anschließend wird das Oberteil 3 mit dem Unterteil 2 verschraubt, wozu sich eine erste Gruppe von Schraubdome 69 vom Boden 12 des Unterteils zum Oberteil 3 erstreckt, in die die entsprechenden Schrauben eingeschraubt werden. Zusätzlich werden das Oberteil 3 und die Trennwand 50 miteinander mittels Schrauben 39 und zylindrische Schraubenaufnahmen 42 verschraubt, wobei die Schraubenaufnahmen 42 einstückig an der Trennwand 50 angeformt sind und sich durch Öffnungen 42a in der zweite Leiterplatte 20a hindurch erstrecken. Die Schraubenaufnahme 42 weisen ein zentrales Loch auf, in das die entsprechende Schraube 39 fest eingeschraubt werden kann.

Die zweite Leiterplatte 20a wird ebenfalls mit dem Unterteil 2 verschraubt. Hierzu ist eine zweite Gruppe von Schraubdomen 67 vorgesehen, die sich vom Boden 12 des Unterteils 2 durch Öffnungen in der Trennwand 50 zur zweiten Leiterplatte 20a erstrecken, in welcher mit den Schraubdomen 67 fluchtende Bohrungen vorhanden sind. Der Umfangsbereich um diese Bohrungen herum ist metallisiert, so dass durch die Verschraubung der zweiten Leiterplatte 20a mit den Schraubdomen 67 das Erdpotenzial auf die zweite Leiterplatte 20a gebracht ist. Durch die Verschraubung der zweiten Leiterplatte 20a wird gleichzeitig die metallische Schirmauflage 53 fixiert, welcher eine Lasche 70 aufweist. Diese Lasche 70 ist durch eine Ausnehmung im Boden 22 des Oberteils 3 geführt und liegt auf dem metallisierten Bereich der Bohrung der zweiten Leiterplatte 20a auf, so dass auch die Schirmauflage 53 durch seine Fixierung automatisch geerdet wird. Durch die Lasche 70 und die zweite Leiterplatte 20a wird eine Schraube 39a geführt und mit einem der Schraubdome 67 verschraubt.

Zuletzt erfolgt die Montage des Anzeige- und/ oder Bedieneinheit 30. Diese wird mit ihren Haltezungen 34 in die Vertiefungen am Oberteil 3 schräg eingesetzt und anschließend mit dem den Haltezungen 34 gegenüberliegenden Seitenschenkel 4a der Blende 4 zum Oberteil 3 hin geklappt, um den dritten Raumbereich 7 zu verschließen. Danach wird die Anzeige- und/ oder Bedieneinheit 30 mit dem Oberteil 3 mittels Schrauben 38 verschraubt.

Die Montage des erfindungsgemäßen Elektronikmoduls ist durch das Bottom-Up Prinzip besonders einfach und schnell.

### Bezugszeichenliste

- 1: Elektronikmodul
- 2: Unterteil
- 3: Oberteil
- 4: Bedienfeldabdeckung, Blende
- 4a: Seitenschenkel der Blende
- 5: erster Raumbereich
- 6: zweiter Raumbereich
- 7: dritter Raumbereich, Anschlussraum
- 8: Anschlussbereich
- 8a-8e: elektrische Kontakte,
- 10: Motorsteuereinheit
- 10a: erste Leiterplatte
- 11: Seitenwand des Unterteils
- 12: Boden des Unterteils
- 12a: Vertiefung im Boden
- 13: Seitenöffnung im Unterteil
- 14: Kühlrippen
- 15: leistungselektronische Bauelemente
- 15a: höchste Bauelemente
- 16: Schnittstelleneinheit
- 17: Erste elektrische Schnittstelle
- 18: Trägerelement
- 19: Rand des Trägerelements
- 20: Systemsteuereinheit
- 20a: zweite Leiterplatte
- 21: Seitenwand des Oberteils
- 22: Boden des Oberteils
- 23: Rücksprung der Oberteilunterkante
- 24: Öffnungen zur Kabeldurchführung
- 25: systemelektronische Bauelemente
- 26: Anschlussklemmen im Anschlussraum
- 27: Zweite elektrische Schnittstelle am Trägerelement
- 28: Dritte elektrische Schnittstelle am Trägerelement
- 29: Sensorkabel
- 30: Anzeige- und/ oder Bedieneinheit
- 31: Elektronik der Anzeige- und/ oder Bedieneinheit
- 32: Display
- 33: Sichtfenster
- 34: Haltezungen
- 35: Bedienelement, Bedientaste
- 36: Bedienknopf
- 37: dreh- drückbares elektrisches Eingabeelement
- 38: Schrauben zur Befestigung der Anzeige- und/ oder Bedieneinheit
- 39: Schrauben zur Verschraubung der Trennwand mit Oberteil
- 40: Elektromotor
- 41: Anschlussbereich für Platinenrandstecker
- 42: Schraubenaufnahme
- 42a: Bohrung in Leiterplatte für Schraubenaufnahme
- 43: Umfangskante des Unterteils
- 44: Öffnung in Trennwand
- 45: Elektrische Verbindung zwischen erster und zweiter Leiterplatte
- 46: Elektrische Verbindung zum Stator des Elektromotors, Statorsteckkontakte
- 47: Elektrische Verbindung zwischen zweiter Leiterplatte und Anzeige und/ oder Bedieneinheit
- 48: Schraubenaufnahme
- 49: Steckkontakte, Flachkontakte
- 50: Trennwand
- 51: Ausnehmung für Schnittstelleneinheit
- 52: hohlzylindrische Kabelführungen
- 53: Schirmauflage
- 53a: Bügelartige Kabelbefestigungen
- 54: Rippenartige Verstärkungsstrukturen
- 54a: Stützrippe
- 55: Schirmwand
- 56: Rahmen
- 57: Oberer Führungsdom
- 58: Unterer Führungsdom
- 59: Unterseite der Trennwand
- 60: Netzstecker
- 61: Externer Sensor
- 62: Interface-Modul
- 63: Schnittstelle für Interface-Modul
- 64: Anschlüsse/ Klemmen des Interface-Moduls
- 65: Leiterplatte
- 66: Anschlussbereich für Platinenrandstecker
- 67: Schraubdom
- 68: Kontaktfedern
- 69: Schraubdom
- 70: Lasche
- 71: Anschrauböse
- 72: Bluetooth-Antenne

## Patentansprüche

1. Elektronikmodul (1) für einen Elektromotor (40) mit einer Elektronik (10, 20) zur Steuerung und/ oder Regelung des Elektromotors (40), die in einem ein Unterteil (2) und ein Oberteil (3) umfassendes Gehäuse (2, 3) aufgenommen ist, in dem ein erster und ein zweiter Raumbereich (5, 6) vorhanden sind, welche durch eine Trennwand (50) voneinander getrennt sind, wobei in dem ersten Raumbereich (5) eine erste Leiterplatte (10a) einer Motorsteuereinheit (10) zur Speisung des Elektromotors (40) einliegt, die Betriebsspannungen einer ersten Spannungsebene trägt, und in dem zweiten Raumbereich (6) eine zweite Leiterplatte (20a) einer Systemsteuereinheit (20) einliegt, die Betriebsspannungen einer zweiten, niedrigeren Spannungsebene trägt, **dadurch gekennzeichnet, dass** die Trennwand (50) für eine elektrische und thermische Isolation zwischen den Leiterplatten (10a, 20a) sorgt und ein separates Bauteil bildet, und der erste Raumbereich (5) mitsamt der ersten Leiterplatte (10a), die Trennwand (50) und der zweite Raumbereich (6) mitsamt der zweiten Leiterplatte (20a) axial übereinander angeordnet sind.

2. Elektronikmodul (1) nach Anspruch 1, **dadurch gekennzeichnet, dass** in dem Oberteil (3) ein axial über dem zweiten Raumbereich (6) liegender, einen Anschlussraum bildender dritter Raumbereich (7) ausgebildet ist und auf dem Oberteil (3) eine den dritten Raumbereich (7) abdeckende, abnehmbare Anzeige- und/ oder Bedieneinheit (30) aufgesetzt ist.

3. Elektronikmodul (1) nach Anspruch 2, **dadurch gekennzeichnet, dass** elektrische Anschlüsse (26, 8a-8e) der zweiten Leiterplatte (20a) durch einen Boden (22) des Oberteils (3) in den dritten Raumbereich (7) hineinragen, der die zweite Leiterplatte (20a) im Übrigen abdeckt.

4. Elektronikmodul (1) nach einem der vorherigen Ansprüche, **dadurch gekennzeichnet, dass** die Anzeige- und/ oder Bedieneinheit (30) dichtend mit dem Oberteil (3) verbunden ist.

5. Elektronikmodul (1) nach einem der vorherigen Ansprüche, **dadurch gekennzeichnet, dass** die elektrischen Anschlüsse (26, 8a-8e) der zweiten Leiterplatte (20a) durch farblich codierte Anschlussklemmen (26) gebildet sind.

6. Elektronikmodul (1) nach einem der vorherigen Ansprüche, **dadurch gekennzeichnet, dass** die Trennwand (50) an ihrem Außenumfang einen zumindest teilweise umlaufenden, hochstehenden Rahmen (56) aufweist.

7. Elektronikmodul (1) nach einem der vorherigen Ansprüche, **dadurch gekennzeichnet, dass** die Trennwand (50) auf ihrer zum Unterteil (2) gerichteten Unterseite (59) randseitig eine umlaufende, insbesondere angeformte Dichtung aufweist, die in dichtender Anlage zum Unterteil (2) steht.

8. Elektronikmodul (1) nach Anspruch 6, **dadurch gekennzeichnet, dass** die Trennwand (50) außenseitig am Rahmen (56) eine umlaufende, insbesondere angeformte Dichtlippe aufweist, die in dichtender Anlage zum Oberteil (3), insbesondere zur Innenseite der Seitenwände des Oberteils (3) steht.

9. Elektronikmodul (1) nach Anspruch 7 und 8, **dadurch gekennzeichnet, dass** die Dichtung zum Unterteil (2) und die Dichtlippe zum Oberteil (3) ineinander übergehen, insbesondere eine Formdichtung bilden.

10. Elektronikmodul (1) nach einem der vorherigen Ansprüche, **dadurch gekennzeichnet, dass** die Trennwand (50) ober- und/ oder unterseitig sich lateral erstreckende Verstärkungsstrukturen (54) in Gestalt rippenartiger Vorsprünge, insbesondere in wabenförmiger Geometrie aufweist.

11. Elektronikmodul (1) nach einem der vorherigen Ansprüche, **dadurch gekennzeichnet, dass** die Trennwand (50) in ihrem mittleren Bereich eine sich zur zweiten Leiterplatte erhebende Stützrippe (54a) zum Abstützen der zweiten Leiterplatte (20a) aufweist.

12. Elektronikmodul (1) nach einem der vorherigen Ansprüche, **dadurch gekennzeichnet, dass** es eine von der ersten und zweiten Leiterplatte (10a, 20a) räumlich getrennte Schnittstelleneinheit (16) mit wenigstens zwei nebeneinander liegenden elektrischen Schnittstellen (17, 27, 28), insbesondere Steck- oder Buchsenkontakten, aufweist, die miteinander über ein gemeinsames Trägerelement (18) verbunden sind, wobei eine erste (17) der Schnittstellen (17, 27, 28) der ersten Spannungsebene zum Anschließen eines Netzsteckers (60) und zumindest eine zweite (27, 28) der Schnittstellen (17, 27, 28) mit der zweiten Spannungsebene zum Anschließen eines Datensteckers zugeordnet ist.

13. Elektronikmodul (1) nach Anspruch 12, **dadurch gekennzeichnet, dass** die Schnittstelleneinheit (16) auf Steckkontakte (49), insbesondere Flachkontakte (49), der ersten Leiterplatte (10a) gesteckt ist, die in einen im Trägerelement (18) ausgebildeten Aufnahmeraum für den Netzstecker (60) hineinragen und von diesem direkt kontaktierbar sind.

14. Elektronikmodul (1) nach Anspruch 13, **dadurch gekennzeichnet, dass** die Schnittstelleneinheit (16) aus dem Trägerelement (18) und einer Leiterplatte (65) mit Oberflächenkontakten besteht, die die elektrischen Kontakte der zumindest einen zweiten Schnittstelle (27, 28) bilden.

15. Elektronikmodul (1) nach einem der Ansprüche 12 bis 14, **dadurch gekennzeichnet, dass** in einer Seitenwand (11) des Unterteils (2) eine zum Oberteil (3) hin offene Seitenöffnung (13) vorhanden ist, in oder an der die Schnittstelleneinheit (16) insbesondere formschlüssig an- oder einliegt, so dass die Schnittstellen (17, 27, 28) von außen zugänglich sind.

16. Elektronikmodul (1) nach einem der Ansprüche 13 bis 15, **dadurch gekennzeichnet, dass** das Trägerelement (18) ein Formteil aus Kunststoff ist.

17. Elektronikmodul (1) nach einem der vorherigen Ansprüche, **dadurch gekennzeichnet, dass** die Anzeige- und/ oder Bedieneinheit (30) eine Elektronik (31) und eine diese abdeckende Blende (4) aufweist.

18. Elektronikmodul (1) nach einem der vorherigen Ansprüche, **dadurch gekennzeichnet, dass** die Trennwand (50) hohlzylindrische Kabelführungen (52) aufweist, die mit Öffnungen (24) im Oberteil (3) fluchten.

19. Elektronikmodul (1) nach Anspruch 18, **dadurch gekennzeichnet, dass** die Kabelführungen (52) jeweils Innengewinde zur Aufnahme je einer Kabelverschraubung aufweisen.

20. Elektronikmodul (1) nach einem der vorherigen Ansprüche, **dadurch gekennzeichnet, dass** die Anzeige- und/ oder Bedieneinheit (30) im Betrieb des Elektromotors (40) unter Fortführung des Betriebs abnehmbar ist.

## Claims

1. Electronics module (1) for an electric motor (40) with electronics (10, 20) for the control and/or regulation of the electric motor (40), contained in a housing (2, 3) comprising a lower section (2) and an upper section (3), having a first and second compartment (5, 6) separated from each other by a partition (50), wherein a first circuit board (10a) of a motor control unit (10) to supply the electric motor (40) is installed in the first compartment (5), carrying the operating voltages of a first voltage level, and a second circuit board (20a) of a system control unit (20) is installed in the second compartment (6), carrying the operating voltages of a second, lower voltage level, **characterised by** the partition (50) providing electrical and thermal insulation between the circuit boards (10a, 20a) and forming a separate component, and the first compartment (5) together with the first circuit board (10a), the partition (50), and the second compartment (6) together with the second circuit board (20a) being arranged axially above each other.

2. Electronics module (1) according to claim 1, **characterised by** the upper section (3) having a third compartment (7) located axially above the second compartment (6) and forming a terminal compartment, and a removable display and/or control unit (30) covering the third compartment (7) being fitted onto the upper section (3).

3. Electronics module (1) according to claim 2, **characterised by** electrical connections (26, 8a-8e) of the second circuit board (20a) projecting through a bottom (22) of the upper section (3) into the third compartment (7), which otherwise covers the second circuit board (20a).

4. Electronics module (1) according to one of the preceding claims, **characterised by** the display and/or control unit (30) forming a sealed connection with the upper section (3).

5. Electronics module (1) according to one of the preceding claims, **characterised by** the electrical connections (26, 8a-8e) of the second circuit board (20a) being formed by colour-coded terminal clamps (26).

6. Electronics module (1) according to one of the preceding claims, **characterised by** the partition (50) having an at least partially circumferential, raised frame (56) along its outer circumference.

7. Electronics module (1) according to one of the preceding claims, **characterised by** the partition (50) on its lower side (59) facing the lower section (2) having a circumferential edge seal, notably an integrally moulded seal, that forms a sealed connection with the lower section (2).

8. Electronics module (1) according to claim 6, **characterised by** the partition (50), on the outside of the frame (56), having a circumferential, notably integrally moulded, sealing lip that forms a sealed connection with the upper section (3), notably the inner side of the side walls of the upper section (3).

9. Electronics module (1) according to claim 7 and 8, **characterised by** the seal to the lower section (2) and the sealing lip to the upper section (3) merging, notably forming a gasket.

10. Electronics module (1) according to one of the preceding claims, **characterised by** the partition (50) having laterally extending reinforcing structures (54) on the upper and/or lower side in the form of rib-like projections, notably in a honeycombed geometry.

11. Electronics module (1) according to one of the preceding claims, **characterised by** the partition (50) having a supporting rib (54a) rising to the second circuit board in its centre section to support the second circuit board (20a).

12. Electronics module (1) according to one of the preceding claims, **characterised by** having an interface unit (16), physically separated from the first and second circuit board (10a, 20a), with at least two side by side electrical interfaces (17, 27, 28), notably plug or socket contacts, that are connected to each other by a joint carrier (18), in which the first (17) of the interfaces (17, 27, 28) is assigned to the first voltage level for the connection of a power plug (60) and at least one second interface (27, 28) of the interfaces (17, 27, 28) is assigned to the second voltage level for the connection of a data plug.

13. Electronics module (1) according to claim 12, **characterised by** the interface unit (16) being connected to plug contacts (49), notably flat contacts (49), of the first circuit board (10a) that project into a recess in the carrier (18) for the power plug (60) and can be contacted by it directly.

14. Electronics module (1) according to claim 13, **characterised by** the interface unit (16) consisting of the carrier (18) and a circuit board (65) with surface contacts that form the electrical contacts of at least one second interface (27, 28).

15. Electronics module (1) according to one of the claims 12 through 14, **characterised by** a side wall (11) of the lower section (2) having a lateral opening (13) that is open towards the upper section (3), in or on which the interface unit (16) is fitted or inserted, notably form-fitting, so that the interfaces (17, 27, 28) are accessible from the outside.

16. Electronics module (1) according to one of the claims 13 through 15, **characterised by** the carrier (18) being a moulded plastic part.

17. Electronics module (1) according to one of the preceding claims, **characterised by** the display and/or control unit (30) having electronics (31) and a faceplate (4) covering the same.

18. Electronics module (1) according to one of the preceding claims, **characterised by** the partition (50) having hollow cylindrical cable guides (52) aligned with openings (24) in the upper section (3).

19. Electronics module (1) according to claim 18, **characterised by** the cable guides (52) respectively having internal threads to receive respectively one cable gland.

20. Electronics module (1) according to one of the preceding claims, **characterised by** the display and/or control unit (30) being removable during operation of the electric motor (40) while operation continues.

## Revendications

1. Module électronique (1) pour un moteur électrique (40) avec un circuit électronique (10, 20) de commande et/ou de régulation du moteur électrique (40) hébergé dans un boîtier (2, 3) comportant une partie inférieure (2) et une partie supérieure (3) et présentant un premier et un deuxième espace (5, 6), séparés par une paroi de séparation (50), sachant que le premier espace (5) contient un premier circuit imprimé (10a) d'un module de commande moteur (10) pour l'alimentation du moteur électrique (40), portant des tensions de service d'un premier niveau de tension, et le deuxième espace contient (6) un second circuit imprimé (20a) d'un module de commande moteur (20), portant les tensions de service d'un second niveau de tension inférieur, **caractérisé en ce que** la paroi de séparation (50) assure l'isolation thermique et électrique entre les circuits électroniques (10a, 20a) et forme un composant distinct, et que le premier espace (5) avec le premier circuit imprimé (10a), la paroi de séparation (50) et le deuxième espace (6) avec le second circuit imprimé (20a) sont axialement superposés.

2. Module électronique (1) selon la revendication 1, **caractérisé en ce que** la partie supérieure (3) contient un troisième espace (7) formant un espace de raccordement axialement placé au-dessus du deuxième espace (6) et qu'un module d'affichage et/ou de commande amovible (30) est posé sur la partie supérieure (3) et recouvre le troisième espace (7).

3. Module électronique (1) selon la revendication 2, **caractérisé en ce que** des raccords électriques (26, 8a-8e) du second circuit imprimé (20a) saillissent du fond (22) de la partie supérieure (3) dans le troisième espace (7) recouvrant par ailleurs le second circuit imprimé (20a).

4. Module électronique (1) selon l'une des revendications précédentes, **caractérisé en ce que** le module d'affichage et/ou de commande (30) est relié de façon étanche avec la partie supérieure (3).

5. Module électronique (1) selon l'une des revendications précédentes, **caractérisé en ce que** les raccords électriques (26, 8a-8e) du second circuit imprimé (20a) sont des bornes de connexion (26) codées par couleurs.

6. Module électronique (1) selon l'une des revendications précédentes, **caractérisé en ce que,** la paroi de séparation (50) présente sur sa circonférence extérieure un cadre du moins en partie périphérique et surélevé (56).

7. Module électronique (1) selon l'une des revendications précédentes, **caractérisé en ce que** la paroi de séparation (50) présente sur sa face inférieure (59) orientée vers la partie inférieure (2) un joint périphérique spécialement moulé sur le bord et formant un système étanche avec la partie inférieure (2).

8. Module électronique (1) selon la revendication 6, **caractérisé en ce que** la paroi de séparation (50) extérieurement sur le cadre (56) présente une lèvre d'étanchéité périphérique spécialement moulée formant un système étanche avec la partie supérieure (3), en particulier vers la face intérieure des parois latérales de la partie supérieure (3).

9. Module électronique (1) selon la revendication 7 et 8, **caractérisé en ce que** le joint vers la partie inférieure (2) et la lèvre d'étanchéité vers la partie supérieure (3) se fondent l'un dans l'autre et forment plus particulièrement un joint profilé.

10. Module électronique (1) selon l'une des revendications précédentes, **caractérisé en ce que** la paroi de séparation (50) présente, au-dessus et/ou au-dessous, des structures renforçantes (54) s'étendant latéralement en forme de protubérances nervurées, plus particulièrement à géométrie alvéolaire.

11. Module électronique (1) selon l'une des revendications précédentes, **caractérisé en ce que** la paroi de séparation (50) présente en son milieu une nervure de soutien (54a) orientée vers le second circuit imprimé pour soutenir le second circuit imprimé (20a).

12. Module électronique (1) selon l'une des revendications précédentes, **caractérisé en ce qu'**il présente, une unité d'interface (16) séparée physiquement du premier et du second circuit imprimé (10a, 20a) avec au moins deux interfaces électriques (17, 27, 28) juxtaposées, plus particulièrement des , contacts mâles ou femelles reliés les uns aux autres par un élément porteur (18) commun, sachant qu'une première (17) des interfaces (17, 27, 28) est associée au premier niveau de tension pour la connexion d'un connecteur réseau (60) et qu'au moins une deuxième (27, 28) des interfaces (17, 27, 28) est associée au second niveau de tension pour la connexion d'un connecteur de données.

13. Module électronique (1) selon la revendication 12, **caractérisé en ce que** l'unité d'interface (16) est enfichée sur des contacts d'enfichage (49), plus particulièrement des contacts plats (49), du premier circuit imprimé (10a) saillissant dans un logement formé dans l'élément porteur (18) pour le connecteur réseau (60) est pouvant être directement mis en contact avec ce dernier.

14. Module électronique (1) selon la revendication 13, **caractérisé en ce que** l'unité d'interface (16) est composée de l'élément porteur (18) et d'un circuit imprimé (65) avec contacts de surface formant les contacts électriques d'au moins une seconde interface (27, 28).

15. Module électronique (1) selon l'une des revendications 12 à 14, **caractérisé en ce qu'**une paroi latérale (11) de la partie inférieure (2) présente une ouverture latérale ouverte (13) vers la partie supérieure (3), dans ou sur laquelle l'unité d'interface (16) repose ou s'engage, en particulier par complémentarité de forme, pour que les interfaces (17, 27, 28) soient accessibles de l'extérieur.

16. Module électronique (1) selon l'une des revendications 13 à 15, **caractérisé en ce que** l'élément porteur (18) est une pièce moulée en plastique.

17. Module électronique (1) selon l'une des revendications précédentes, **caractérisé en ce que** le module d'affichage et/ou de commande (30) présente un circuit électronique (31) recouvert par un cache (4).

18. Module électronique (1) selon l'une des revendications précédentes, **caractérisé en ce que,** la paroi de séparation (50) présente conduits de câbles cylindriques creux (52), alignés sur des ouvertures (24) de la partie supérieure (3).

19. Module électronique (1) selon la revendication 18, **caractérisé en ce que** les conduits de câbles (52) présentent chacun un filetage intérieur de fixation d'un presse-étoupe.

20. Module électronique (1) selon l'une des revendications précédentes, **caractérisé en ce que** le module d'affichage et/ou de commande (30) amovible peut être retiré pendant le fonctionnement du moteur électrique (40) sans arrêter celui-ci.
